# EUROPEAN PATENT SPECIFICATION

(11) **EP 2 257 430 B1**
(45) Date of publication and mention of the grant of the patent: **16.01.2013**
(21) Application number: 09720201.4
(22) Date of filing: 12.03.2009
(51) Int. Cl.: B32B 27/10, B32B 27/30, C23C 14/20, C23C 14/58, D21H 19/20, D21H 19/40, D21H 19/60, D21H 19/82

(54) **PACKAGING LAMINATE, METHOD FOR MANUFACTURING OF THE PACKAGING LAMINATE AND PACKAGING CONTAINER PRODUCED THEREFROM**
VERPACKUNGSLAMINAT, VERFAHREN ZUR HERSTELLUNG DES VERPACKUNGSLAMINATS UND DARAUS HERGESTELLTER VERPACKUNGSBEHÄLTER
STRATIFIÉ D EMBALLAGE, PROCÉDÉ DE FABRICATION DU STRATIFIÉ D EMBALLAGE ET CONTENANT D EMBALLAGE PRODUIT À PARTIR DU STRATIFIÉ D EMBALLAGE

(30) Priority: 14.03.2008 SE 0800605
(43) Date of publication of application: 08.12.2010
(73) Proprietor: Tetra Laval Holdings & Finance S.A., 1009 Pully (CH)
(72) Inventor: TOFT, Nils, S-22472 Lund (SE); JACCOUD, Bertrand, CH-1678 SIVIRIEZ (CH); CHIQUET, André, CH-1762 Givisiez (CH); ROCHAT, Gil, CH-1684 Mézières (CH); FAYET, Pierre, CH-1006 Lausanne (CH); BONNÉBAULT, Alain, CH-1913 Saillon (CH); CAMACHO, Walker, S-127 61 Skärholmen (SE)
(74) Representative: Persson, Eva Kerstin Ch.
(86) International application number: PCT/EP2009/001766
(87) International publication number: WO 2009/112255

(56) References cited:
- WO-A-01/17771
- WO-A-2006/027662
- DE-A1- 4 445 193

## Description

### TECHNICAL FIELD

The present invention relates to a non-foil packaging laminate for liquid food packaging comprising a core layer of paper or paperboard, outermost liquid tight, heat sealable layers of polyolefin and, coated onto the inner side of the layer of paper or paperboard, an oxygen gas barrier layer formed by liquid film coating of a liquid gas barrier composition and subsequent drying, the liquid composition containing a polymer binder dispersed or dissolved in an aqueous or solvent-based medium. The invention also relates to a method for manufacturing of the packaging laminate and to a packaging container that is made from the packaging laminate.

### BACKGROUND OF THE INVENTION

Packaging containers of the single use disposable type for liquid foods are often produced from a packaging laminate based on paperboard or carton. One such commonly occurring packaging container is marketed under the trademark Tetra Brik Aseptic@ and is principally employed for aseptic packaging of liquid foods such as milk, fruit juices etc, sold for long term ambient storage. The packaging material in this known packaging container is typically a laminate comprising a bulk core layer of paper or paperboard and outer, liquid-tight layers of thermoplastics. In order to render the packaging container gas-tight, in particular oxygen gas-tight, for example for the purpose of aseptic packaging and packaging of milk or fruit juice, the laminate in these packaging containers normally comprises at least one additional layer, most commonly an aluminium foil.

On the inside of the laminate, i.e. the side intended to face the filled food contents of a container produced from the laminate, there is an innermost layer, applied onto the aluminium foil, which innermost, inside layer may be composed of one or several part layers, comprising heat sealable adhesive polymers and/or polyolefins. Also on the outside of the core layer, there is an outermost heat sealable polymer layer.

The packaging containers are generally produced by means of modern, high-speed packaging machines of the type that form, fill and seal packages from a web or from prefabricated blanks of packaging material. Packaging containers may thus be produced by reforming a web of the laminated packaging material into a tube by both of the longitudinal edges of the web being united to each other in an overlap joint by welding together the inner- and outermost heat sealable thermoplastic polymer layers. The tube is filled with the intended liquid food product and is thereafter divided into individual packages by repeated transversal seals of the tube at a predetermined distance from each other below the level of the contents in the tube. The packages are separated from the tube by incisions along the transversal seals and are given the desired geometric configuration, normally parallelepipedic, by fold formation along prepared crease lines in the packaging material.

The main advantage of this continuous tube-forming, filling and sealing packaging method concept is that the web may be sterilised continuously just before tube-forming, thus providing for the possibility of an aseptic packaging method, i.e. a method wherein the liquid content to be filled as well as the packaging material itself are reduced from bacteria and the filled packaging container is produced under clean circumstances such that the filled package may be stored for a long time even at ambient temperature, without the risk of growth of micro-organisms in the filled product. Another important advantage of the Tetra Brik® -type packaging method is, as stated above, the possibility of continuous high-speed packaging, which has considerable impact on cost efficiency.

A layer of an aluminium foil in the packaging laminate provides gas barrier properties quite superior to most polymeric gas barrier materials. The conventional aluminium-foil based packaging laminate for liquid food aseptic packaging is the most cost-efficient packaging material, at its level of performance, available on the market today. Any other material to compete must be more cost-efficient regarding raw materials, have comparable food preserving properties and have a comparably low complexity in the converting into a finished packaging laminate.

Hitherto, there are hardly any aseptic paper- or paperboard-based packages for long-term ambient storage of the above described kind available on the market, from a cost-efficient, non-foil packaging laminate, as compared to aluminium-foil laminates, that have a reliable level of barrier properties and food preservation properties for more than 3 months. There are some polymer materials that provide good barrier properties, but they either have the wrong mechanical properties in the laminate or are difficult to process in the converting into thin layers in laminates, e.g. requiring expensive coextruded tie layers, or, they may, moreover, be considerably more expensive at feasible thickness than aluminium and are, therefore, not cost-efficient for packaging of e.g. milk or juice.

Among the efforts of developing more cost-efficient packaging materials and minimizing the amount of raw material needed for the manufacturing of packaging materials, there is a general incentive towards developing premanufactured films having multiple barrier functionalities, which may replace the aluminium-foil. Previously known such examples are films combining multiple layers, which each contribute with complementing barrier properties to the final film, such as for example films having a vapour deposited barrier layer and a further polymer-based barrier layer coated onto the same substrate film. Such films, which have been coated two times with different coating methods, tend, however, to become very expensive both in raw material and manufacturing costs, also due to the fact that in most cases an additional sealing layer is needed, and will involve very high demands on the qualities of the substrate film, such as thermal resistance and handling durability.

There is one type of polymer gas barrier layers that could be very cost-efficient, i.e. barrier polymers that are coated in the form of a dispersion or solution in a liquid or solvent, onto a substrate, and subsequently dried into thin barrier coatings. It is, however, very important that the dispersion or solution is homogeneous and stable, to result in an even coating with uniform barrier properties. Examples of suitable polymers for aqueous compositions are polyvinyl alcohols (PVOH), water-dispersible ethylene vinyl alcohols (EVOH) or polysaccharide-based water-dispersible or dissolvable polymers. Such dispersion coated or so called liquid film coated (LFC) layers may be made very thin, down to tenths of a gram per m², and may provide high quality, homogenous layers, provided that the dispersion or solution is homogeneous and stable, i.e. well prepared and mixed. It has been known for many years that e.g. PVOH has excellent oxygen barrier properties under dry conditions. PVOH also provides very good odour barrier properties, i.e. capability to prevent odour substances from entering the packaging container from the surrounding environment, e.g. in a fridge or a storage room, which capability becomes important at long-term storage of packages. Furthermore, such liquid film coated polymer layers from water-dispersible or -dissolvable polymers often provide good internal adhesion to adjacent layers, which contributes to good integrity of the final packaging container. With package integrity is generally meant the package durability, i.e. the resistance to leakage of a packaging container. Such water dispersible barrier polymers have a major draw-back, however, in that they are generally sensitive to moisture and that the oxygen gas barrier properties deteriorate rapidly at high relative moisture content in the packaging laminate. Consequently, a thin dispersion coated layer of PVOH or EVOH or a similar polymer, may be suitable for packaging of dry products in a dry environment, but much less for packaging of liquids and wet products or for storage under wet or humid conditions.

It has, moreover, been seen that the rather good oxygen barrier properties of a flat packaging laminate having a layer of dispersion coated barrier polymer (as compared to aluminium foil), were severely decreased during converting and transforming into packaging containers.

It has, therefore, previously been attempted to provide the moisture sensitive polymer layer with better initial oxygen barrier properties, as well as rendering it more moisture resistant, by modifying the polymer or including other substances in the polymer composition, i.a. by crosslinking the polymer. Such modifications and addition of substances, however, often make the process of liquid film coating more difficult to control and, importantly, more expensive. Such substances may also need careful screening in view of existing food safety legislations for food packaging. It has, for example, also been attempted to heat cure a dispersion coated PVOH layer in connection with the drying thereof, by heating it up to above 100 °C. However, such heat may damage the coated paperboard substrate and negatively influence the coating quality, for example by inducing defects, such as blisters and cracks in the oxygen barrier coating. Accordingly, there is still a need for a cost-efficient and robust, i.e. reliable also at moderate variations in manufacturing and handling conditions, non-aluminium foil packaging material for aseptic, liquid food packaging, e.g. of milk or other beverage, which material provides sufficient barrier properties in packaging containers for long-term aseptic storage, under ambient conditions. With the term "long-term storage" in connection with the present invention, is meant that the packaging container should be able to preserve the qualities of the packed food product, i.e. nutritional value, hygienic safety and taste, at ambient conditions for at least 3 months, preferably longer.

DE 4445193A1 relates to recyclable, laminates of coated paper or paperboard having oxygen barrier properties, however not for liquid carton type packaging, coated with several material layers on top of each other, first a polymer layer and there onto a metallised layer, and in turn, on top of the metallised layer a further polymer over-coat. The polymer material layers as exemplified (EAA) are not actually by themselves providing oxygen barrier properties (see the comparative examples 1-4) but are shown to interact with the metallisation surface to improve oxygen barrier properties altogether, as long as the polymer contains functional carboxylic groups. Polymers like polyethylene or polyvinylchloride or polyvinylidenechloride are not desirable in the laminate of D1, for environmental profile and recycling reasons.

### DISCLOSURE OF THE INVENTION

It is, therefore, an object of the present invention to overcome or alleviate the above-described problems in producing a non-foil paper or paperboard packaging laminate for long-term, aseptic packaging of liquid or wet food.

It is a general object of the invention to provide a non-foil, paper or paperboard packaging laminate, having good gas barrier properties suitable for long-term, aseptic packaging and good internal adhesion between the layers, providing for good integrity of a packaging container manufactured from the laminate.

Especially, it is an object to provide a cost-efficient, non-foil, paper- or paperboard-based packaging laminate, providing for good gas barrier properties of a packaging container, good package integrity and good internal adhesion between the layers of the laminate.

It is a further object of the invention to provide a, relative to aluminium foil, cost-efficient, non-foil paper or paperboard packaging laminate having good gas barrier properties, good water vapour barrier properties and good internal adhesion properties for the purpose of manufacturing aseptic, gas-tight and water-vapour tight packaging containers, having good package integrity.

Yet a further object of the invention is to provide a cost-efficient and robust, non-foil, paper- or paperboard-based and heat-sealable packaging laminate having good gas barrier properties, good water vapour barrier properties and good internal adhesion properties for the purpose of manufacturing aseptic packaging containers for long-term storage of liquid foods at maintained nutritional quality under ambient conditions.

A more specific object, according to at least some of the embodiments of the invention, is to provide a cost-efficient, non-foil, paper- or paperboard-based liquid packaging container having good gas and water vapour barrier properties, good odour barrier properties, and good integrity for aseptic packaging of milk, at long-term storage under ambient conditions.

These objects are thus attained according to the present invention by the laminated packaging material, the packaging container and the method of manufacturing the packaging material, as defined in the appended claims.

According to a first aspect of the invention, the general objects are attained by a packaging laminate comprising a core layer of paper or paperboard, a first outermost liquid tight, heat sealable polyolefin layer, a second innermost liquid tight, heat sealable polyolefin layer and, coated directly onto and adjacent the inner side of the core layer of paper or paperboard, an oxygen gas barrier layer formed by liquid film coating of a liquid gas barrier composition and subsequent drying, the liquid composition containing a polymer binder dispersed or dissolved in an aqueous or solvent medium, wherein the packaging laminate further comprises a vapour deposited barrier layer coated onto a polymer substrate film, which polymer substrate film optionally comprises the innermost heat sealable polyolefin layer, wherein the vapour deposited barrier layer is arranged between said oxygen gas barrier layer and the innermost heat sealable polyolefin layer, and wherein the vapour deposited barrier layer-coated film is bonded to the oxygen gas barrier-coated core layer by an intermediate polymer layer.

It was, thus, expected that in order to reach the required level of oxygen barrier properties in a final packaging container for aseptic, long-term storage, the liquid film coatable gas barrier polymer binder, e.g. PVOH, would have to be improved by new means or by some of the known modification methods, i.e. the addition of a crosslinking substance or by heat curing. Still, it would be uncertain if the improvement in oxygen barrier would be strong enough for aseptic packaging and long-term, ambient storage.

A packaging laminate for use in packaging containers for aseptic, long-term storage, needs also improved water vapour barrier properties.

With water vapour barrier properties is meant a barrier against slowly migrating water vapour through the material, i.e. not the immediate liquid barrier properties. As an example, heat sealable polyolefins, such as the preferred low density polyethylenes (LDPE's or LLDPE's), are liquid barriers and are suitable as outermost layers to protect the paperboard inside of a laminate against the filled liquid product or against wet conditions outside the package, such as at high humidity or chilled storage. Low density polyethylene has, however, comparably low water vapour barrier properties, i.e. actually no capability at reasonable thickness, to withstand the long-term, slow migration of water vapour through the laminate during shipping and storage. Water vapour barrier properties are important during long-term storage, also because they prevent moisture from a packaged liquid food product from escaping out of a packaging container, which could result in a lower content of liquid food product than expected in each packaging container, when finally opened by the consumer. Possibly also the composition and the taste of the product could be altered by becoming more concentrated. Moreover, by preventing water vapour from migrating escaping out of the packaging container into the paper or paperboard layer, the packaging laminate will be able to keep its stiffness properties for a longer time. Thus, it is important that the packaging material also has sufficient water vapour barrier properties to be suitable for long-term aseptic packaging of liquid products.

Thin aluminium metallised layers, i.e.vapour deposited layers of aluminium metal, are known to provide water vapour barriers. However, when manufacturing cost efficient, paper-based packaging laminates comprising such layers it has been seen, that the oxygen barrier properties are not sufficient.

The conventional aluminium foil used today in commercial packaging containers for aseptic, liquid food, has both water vapour barrier properties and oxygen barrier properties. There are hardly any suitable, cost-efficient material alternatives providing both reliable oxygen barrier and water vapour barrier comparable to aluminium foil.

Very surprisingly, however, when producing packaging containers by laminating two such separated and different barrier materials to each other, i.e. one having a liquid film coated PVOH barrier layer, and another having a vapour deposited barrier layer, it was found that not only sufficient water vapour barrier properties were achieved, but also that the oxygen barrier properties of the finished packaging laminate and, in particular, of the final package were surprisingly improved and suddenly well above sufficient. The contribution of the vapour deposited compound layer to the oxygen barrier properties of the finished packaging laminate should have been insufficient, but was much higher than expected and calculated, from the values of oxygen transmission measured on each of the barrier layers separately. In fact, the inclusion of a film with a vapour deposited metal layer, having a rather high oxygen transmission by itself, improved the oxygen barrier of the finished packaging laminate by a factor of more than 2, compared to a corresponding packaging laminate without the vapour deposited film.

Moreover, after converting and forming into a packaging container, synergetic, further surprisingly improved oxygen barrier properties were obtained. Although the contribution from the inclusion of e.g. a metallised layer to the total oxygen barrier of the finished packaging laminate was surprising, the oxygen barrier properties in the final package were even further improved by a factor of more than 20, compared to a packaging container from a corresponding laminate without the vapour deposited film.

It was later also found that defects in the dispersion coated layer, resulting in impaired oxygen barrier properties of flat samples of the packaging laminate with the dispersion coated layer, are "repaired" or "healed" by the thin layer of vapour deposited compound in an unexpected manner.

This repairing or healing effect has for example been seen when using different paperboard qualities for packaging laminates according to the invention. Some paperboard grades seem less suitable for liquid film coating of an oxygen barrier layer in that the oxygen gas barrier measured on flat packaging laminate may vary a lot between different grades. However, the differences are evened out by the additional thin vapour deposited barrier layer on the inside of the liquid film coated layer. It seems that defects like pinholes or micro-cracks likely are created in the thin liquid film coated layer when coating low quality paperboard, and that when laminating to a thin vapour deposited layer having some barrier properties, these defects are healed and do not much affect the properties of the final package.

It is preferred that, the dispersible or dissolvable polymer binder used for the present invention is a polymer having gas barrier properties by itself.

Preferably, the polymer is selected from the group consisting of vinyl alcohol-based polymers, such as PVOH or water dispersible EVOH, acrylic acid or methacrylic acid based polymers (PAA, PMAA), polysaccharides such as for example starch or starch derivatives, chitosan or other cellulose derivatives, water dispersible polyvinylidenechloride (PVDC) or water dispersible polyesters, or combinations of two or more thereof.

More preferably, the polymer binder is selected from the group consisting of PVOH, water dispersible EVOH, acrylic acid or methacrylic acid based polymers (PAA, PMAA), polysaccharides such as for example starch or starch derivatives, chitosan or other cellulose derivatives, or combinations of two or more thereof.

In comparison with aluminium foil, PVOH as a liquid film coating barrier polymer enjoys many desirable properties, with the result that it is the most preferred barrier material in many contexts. Among these, mention might be made of the good film formation properties, compatibility with foods and economic value, together with its high oxygen gas barrier properties. In particular, PVOH provides a packaging laminate with high odour barrier properties, which is especially important for the packaging of milk.

Like many other conceivable barrier polymers such as, for example, starch or starch derivatives, polyvinyl alcohol is suitably applied by means of a liquid film coating process, i.e. in the form of an aqueous or solvent-based dispersion or solution which, on application, is spread out to a thin, uniform layer on the substrate and thereafter dried. We have found that one drawback in this process is, however, that the liquid polymer dispersion or polymer solution which is applied on a core layer of paper or paperboard may penetrate into the liquid-absorbing fibres of the core layer. There is a risk of pinholes being formed, depending on paperboard characteristics, if the applied layer is too thin, in connection with the removal of water or solvent for drying the applied barrier layer.

Aqueous systems generally have certain environmental advantages. Preferably, the liquid gas barrier composition is water-based, because such composition usually have a better work environment friendliness than solvent-based systems, as well.

As briefly mentioned above, it is known to include a polymer or compound with functional carboxylic acid groups, in order to improve the water vapour and oxygen barrier properties of a PVOH coating. Suitably, the polymer with functional carboxylic acid groups is selected from among ethylene acrylic acid copolymer (EAA) and ethylene methacrylic acid copolymers (EMAA) or mixtures thereof. One known such particularly preferred barrier layer mixture consists of PVOH, EAA and an inorganic laminar compound. The EAA copolymer is then included in the barrier layer in an amount of about 1-20 weight %, based on dry coating weight.

It is believed that the improved oxygen and water barrier properties result from an esterification reaction between the PVOH and the EAA at an increased drying temperature, whereby the PVOH is crosslinked by hydrophobic EAA polymer chains, which thereby are built into the structure of the PVOH. Such a mixture is, however, considerably more expensive because of the cost of the additives. Furthermore, drying and curing at elevated temperatures is not preferred because the risk of crack and blisters formation in a barrier coating onto a paperboard substrate. Crosslinking can also be induced by the presence of polyvalent compounds, e.g. metal compounds such as metal-oxides. However, such improved liquid film coated gas barrier layers still are not able to by themselves provide a cost-efficient and well-formed packaging container with sufficient oxygen barrier properties for reliable, long-term aseptic packaging at ambient storage.

Special kinds of water-dispersible ethylene vinyl alcohol polymer (EVOH) have lately been developed and may be conceivable for an oxygen barrier liquid coating composition, according to the invention. Conventional EVOH polymers, however, are normally intended for extrusion and are not possible to disperse/dissolve in an aqueous medium in order to produce a thin liquid film coated barrier film of 5 g/m² or below, preferably 3,5 g/m² or below. It is believed that the EVOH should comprise a rather high amount of vinyl alcohol monomer units to be water-dispersible or dissolvable and that the properties should be as close to those of liquid film coating grades of PVOH as possible. An extruded EVOH layer is not an alternative to liquid film coated EVOH, because it inherently has less similar properties to PVOH than EVOH grades for extrusion coating, and because it cannot be applied at a cost-efficient amount below 5 g/m² as a single layer by extrusion coating or extrusion lamination, i.e. it requires co-extruded tie layers, which are generally very expensive polymers. Furthermore, very thin extruded layers cool off too quickly and do not contain enough heat energy to sustain sufficient lamination bonding to the adjacent layers.

Other examples of polymer binders providing oxygen barrier properties, suitable for liquid film coating, are the polysaccharides, in particular starch or starch derivatives, such as preferably oxidised starch, cationic starch and hydroxpropylated starch. Examples of such modified starches are hypochlorite oxidised potato starch (Raisamyl 306 from Raisio), hydroxypropylated corn starch (Cerestar 05773) etc. However, also other starch forms and derivatives are known to provide gas barrier properties at some level.

Further examples of polymer binders are gas barrier coatings comprising mixtures of carboxylic acid containing polymers, such as acrylic acid or methacrylic acid polymers, and polyalcoholic polymers, such as PVOH or starch, which are described for example in EP-A- 608808, EP-A-1086981 and W02005/037535. A cross-linking reaction of these polymer binders is preferred, as mentioned above, for resistance to high humidity.

Also mixtures with only a minor mixing ratio of one of the components and even compositions from a sole one of these components do provide oxygen barrier properties in an aqueous coating composition.

Most preferably, however, the gas barrier polymer is PVOH, because it has all the good properties mentioned above, i.e. film formation properties, gas barrier properties, cost efficiency, food compatibility and odour barrier properties.

A PVOH-based gas barrier composition performs best when the PVOH has a degree of saponification of at least 98 %, preferably at least 99 %, although PVOH with lower degrees of saponification will also provide oxygen barrier properties.

According to a preferred embodiment, the liquid composition additionally comprises inorganic particles in order to further improve the oxygen gas barrier properties.

The polymer binder material may for example preferably be mixed with an inorganic compound which is laminar in shape, or flake-formed. By the layered arrangement of the flake-shaped inorganic particles, an oxygen gas molecule has to migrate a longer way, via a tortuous path, through the oxygen barrier layer, than the normal straight path across a barrier layer.

When employing inorganic laminar particles, it may be possible to use a polymer binder having no, or substantially lower, oxygen barrier properties. Examples of such other non-barrier binders are other high hydrogen-bonding polymers having a high amount of hydrogen-bonding groups like hydroxyl groups, amino groups, carboxyl groups, sulfonic acid groups, carboxylate groups, sulfonate ion groups, ammonium groups and the like. Specific examples of such non-barrier polymer binders are i.a. cellulose derivatives such as hydroxymethyl (or ethyl) cellulose, amylopectin, and other polysaccharide derivatives, polyethyleneimine, polyallylamine etc.

Preferably, the inorganic laminar compound is a so-called nanoparticle compound dispersed to an exfoliated state, i.e. the lamellae of the layered inorganic compound are separated from each other by means of a liquid medium. Thus the layered compound preferably may be swollen or cleaved by the polymer dispersion or solution, which at dispersion has penetrated the layered structure of the inorganic material. It may also be swollen by a solvent before added to the polymer solution or polymer dispersion. Thus, the inorganic laminar compound is dispersed to a delaminated state in the liquid gas barrier composition and in the dried barrier layer. The term clay minerals includes minerals of the kaolinite, antigorite, smectite, vermiculite, bentonite or mica type, respectively. Specifically, laponite, kaolinite, dickite, nacrite, halloysite, antigorite, chrysotile, pyrophyllite, montmorillonite, hectorite, saponite, sauconite, sodium tetrasilicic mica, sodium taeniolite, common mica, margarite, vermiculite, phlogopite, xanthophyllite and the like may be mentioned as suitable clay minerals. Especially preferred nanoparticles are those of montmorillonite, most preferred purified montmorillonite or sodium-exchanged montmorillonite (Na-MMT). The nano-sized inorganic laminar compound or clay mineral preferably has an aspect ratio of 50-5000 and a particle size of up to about 5 µm in the exfoliated state.

Preferably, the inorganic particles mainly consist of such laminar bentonite particles having an aspect ratio of from 50 to 5000.

Preferably, the barrier layer includes from about 1 to about 40 weight %, more preferably from about 1 to about 30 weight % and most preferably from about 5 to about 20 weight %, of the inorganic laminar compound based on dry coating weight. If the amount is too low, the gas barrier properties of the coated and dried barrier layer will not be markedly improved compared to when no inorganic laminar compound is used. If the amount is too high, the liquid composition will become more difficult to apply as a coating and more difficult to handle in storage tanks and conduits of the applicator system. Preferably, the barrier layer includes from about 99 to about 60 weight %, more preferably from about 99 to about 70 weight % and most preferably from about 95 to about 80 weight % of the polymer based on the dry coating weight. An additive, such as a dispersion stabiliser or the like, may be included in the gas barrier composition, preferably in an amount of not more than about 1 weight % based on the dry coating. The total dry content of the composition is preferably from 5 to 15 weight-%, more preferably from 7 to 12 weight-%.

According to a different preferred embodiment, the inorganic particles mainly consist of laminar talcum particles having an aspect ratio of from 10 to 500. Preferably, the composition comprises an amount of from 10 to 50 weight-%, more preferably from 20 to 40 weight-% of the talcum particles, based on dry weight. Below 20 weight-%, there is no significant increase in gas barrier properties, while above 50 weight-%, the coated layer may be more brittle and breakable because there is less internal cohesion between the particles in the layer. The polymer binder seems to be in too low an amount to surround and disperse the particles and laminate them to each other within the layer. The total dry content of such a liquid barrier composition from PVOH and talcum particles may be between 5 and 25 weight-%.

It is also known from WO03/031720, that surprisingly good oxygen barrier properties may be achieved when there is made use of colloidal silica particles, exhibiting a particle size of 3-150 nm, preferably 4-100 nm and even more preferred 5-70 nm, which particles are preferably amorphous and spherical. The use of colloidal silica particles moreover has the advantage that the liquid barrier composition may be applied at a dry content of 15-40 weight %, preferably 20-35 weight % and even more preferred 24-31 weight %, whereby the demand on forcible drying is decreased.

Less preferred alternatives of inorganic particles according to the invention are particles of kaolin, mica, calcium carbonate etc.

The preferred polymer binder, also when employing inorganic particles for providing oxygen barrier properties, is PVOH, partly due to its advantageous properties mentioned above. In addition, PVOH is advantageous from a mixing point of view, i.e. it is generally easy to disperse or exfoliate inorganic particles in an aqueous solution of PVOH to form a stable mixture of PVOH and particles, thus enabling a good coated film with a homogeneous composition and morphology.

Preferably, according to the invention, the said oxygen gas barrier layer is applied at a total amount of from 0,1 to 5 g/m², preferably from 0,5 to 3,5 g/m², more preferably from 0,5 to 2 g/m², dry weight. Below 0,1 g/m², there will be no gas barrier properties achieved at all, while above 5 g/m², the coated layer will not bring cost-efficiency to the packaging laminate, due to high cost of barrier polymers in general and due to high energy cost for evaporating off the liquid. A recognisable level of oxygen barrier is achieved by PVOH at 0,5 g/m² and above, and a good balance between barrier properties and costs is achieved between 0,5 and 3,5 g/m².

According to a preferred embodiment of the invention, the oxygen gas barrier layer is applied in two consecutive steps with intermediate drying, as two part-layers. When applied as two part-layers, each layer is suitably applied in amounts from 0,1 to 2,5 g/m², preferably from 0,5 to 1 g/m², and allows a higher quality total layer from a lower amount of liquid gas barrier composition. More preferably, the two part-layers are applied at an amount of from 0,5 to 2 g/m² each, preferably from 0,5 to 1 g/m² each.

According to the invention the oxygen gas barrier layer is coated directly onto, and adjacent, the core layer of paper or paperboard. The paper layer ensures that moisture that migrates outwards through the laminated packaging material and is not trapped in the moisture sensitive liquid film coated oxygen gas barrier layer, but further transported via the paper layer towards the outside of the packaging container. The paper layer breathes away the humidity from the adjacent barrier layer and keeps the moisture content within the barrier layer at an almost constant low level for a long time.

A paper or paperboard core layer for use in the invention usually has a thickness of from about 100 µm up to about 600 µm, and a surface weight of approximately 100-500 g/m², preferably about 200-300 g/m², and may be a conventional paper or paperboard of suitable packaging quality.

For low-cost aseptic, long-term packaging of liquid food, a thinner packaging laminate may be used, having a thinner paper core layer. The packaging containers made from such packaging laminates are not fold-formed and more similar to pillow-shaped flexible pouches. A suitable paper for such pouch-packages usually has a surface weight of from about 50 to about 140 g/m², preferably from about 70 to about 120 g/m², more preferably from 70 to about 110 g/m².

Suitable thermoplastics for the outermost and innermost heat sealable liquid-tight layers are polyolefins, preferably polyethylenes and most preferably low density polyethylenes such as, for example LDPE, linear LDPE (LLDPE) or single site catalyst metallocene polyethylenes (m-LLDPE) or blends thereof.

The vapour deposited barrier layer is applied by means of physical vapour deposition (PVD) or chemical vapour deposition (CVD) onto a polymer substrate film.

The thin vapour deposited layers according to the invention are nanometer-thick, i.e. they have a thickness that is most suitably counted in nanometers, for example of from 5 to 500 nm (50 to 5000 A), preferably from 5 to 200 nm, more preferably from 5 to 100 nm and most preferably from 5 to 50 nm.

Generally, below 5 nm the barrier properties may be too low to be useful and above 200 nm, the coating is less flexible and, thus, more prone to cracking when applied onto a flexible substrate.

Commonly, such a vapour deposition coating having barrier properties is made of a metal compound or an inorganic metal compound. There are also organic vapour deposited barrier coatings, such as carbon-based vapour deposition coatings, e.g. amorphous carbon layers or so-called diamond-like carbon coatings, which may be advantageous for packaging laminates and packaging containers according to the invention.

Preferably, the thin vapour deposited layer substantially consists of aluminium metal. Such a metallic thin vapour deposited layer preferably has a thickness of from 5 to 50 nm, more preferably from 5-30 nm, which corresponds to less than 1 % of the aluminium metal material present in an aluminium foil of conventional thickness, i.e. 6,3 µm.

Preferably, a step of surface treatment of the substrate film is carried out before vapour deposition coating, especially metallising, the substrate film, e.g. by ion bombardment of the surface.

Preferably, the metallised layer has an optical density (OD) of from 1.8 to 3.0, preferably from 2.0 to 2.7. At an optical density lower than 1.8, the barrier properties of the metallised film are too low. At above 3.0, on the other hand, the metallisation layer becomes too brittle, and the thermostability during the metallisation process will be too low due to higher heat load when metallising the substrate film during a longer time. The coating quality and adhesion will then be clearly negatively affected. An optimum has, thus, been found between these values, preferably between 2.0 and 2.7.

A further preferable coating is a coating of aluminium oxide having the formula AlOx wherein x varies from 1.0 to 1.5, preferably of Al₂O₃. Preferably, the thickness of such a coating is from 5 to 300 nm, more preferably from 5 to 100 nm and most preferably from 5 to 50 nm.

Normally, an aluminium metallised layer inherently has a thin surface portion consisting of an aluminium oxide due to the nature of the metallisation coating process used.

A thin coating metallisation layer, or a layer of an inorganic metal compound, is preferably applied by means of vacuum vapour deposition, but may less preferably be applied also by other methods generally known in the art having a lower productivity, such as electroplating or sputtering. The most preferred metal according to the present invention is aluminium, although any other metal capable of being vacuum deposited, electroplated or sputtered may be used according to the invention. Thus, less preferred and less common metals such as Au, Ag, Cr, Zn, Ti or Cu are conceivable also. Generally, thin coatings of metal or a mixture of metal and metal oxide provide barrier properties against water vapour and are used when the desired function is to prevent water vapour from migrating into and through the multilayer film or packaging laminate. Most preferably, the metal in a metallisation or inorganic metal coating is aluminium (Al). Further examples of aluminium inorganic compounds are aluminium oxide, nitride and aluminium carbide, or a mixture of these.

Although aluminium metal or aluminium oxide layers or mixtures thereof are preferred according to the invention, also other vapour deposited inorganic metal compound layers may be suitable for carrying out the invention. Also similar compounds from semi-metals such as silicon may be suitable for the invention and are included by the term inorganic metal compounds, as long as they are cost-efficient and have at least some low level of oxygen barrier properties.

Some of these inorganic coatings may be applied by means of plasma enhanced chemical vapour deposition method (PECVD), wherein metal or metal compound vapour is deposited onto the substrate under more or less oxidising circumstances. Silicon oxide coatings may, for example, be applied by a PECVD process.

According to another preferred embodment, according to the invention, the vapour deposition coating may be a thin carbon-based barrier layer. Such carbon-based layers may be coated by means of a plasma coating process, resulting in a hydrocarbon polymer coating, referred to as amorphous carbon or diamond-like carbon (DLC) coatings.

The substrate polymer film may comprise any polymer film from any polymer suitable for vapour deposition coating and of any thickness as long as it will provide for a packaging container having good barrier properties and integrity properties in handling and distribution. The choice of substrate film however affects the costs of resulting packaging material and packaging containers to large extent, so polyethylene-based substrate films are preferred. However, films including for example polyethyleneterephthalate (PET), polyamide (PA) or other thermoplastic polymers are also feasible within the scope of the invention, depending on pricing. Such commercially available films are often bi-axially oriented. Such films constitute a more expensive alternative, also due to the fact that they are not heat sealable in themselves, but need an additional heat sealing layer applied to one side, commonly applied by means of extrusion coating when laminating into a packaging laminate. The substrate film may be oriented or non-oriented depending on the choice of polymer and may be produced by means of extrusion blowing film manufacturing methods or by means of extrusion casting film manufacturing methods.

According to a preferred embodiment of the invention, the vapour deposition coated barrier layer is applied onto a substrate polymer film including said innermost heat sealable polymer layer.

Preferably, the substrate polymer film is polyolefin-based. Preferably, the innermost heat sealable polymer layer is mainly consisting of a low density polyethylene, preferably linear low density polyethylene (LLDPE).

More preferably, the substrate polymer film is a mono-oriented film comprising said innermost heat sealable polymer. By mono-orienting the film, increased Young's modulus as well as decreased elongation at break is obtained in the film. This will make it possible to vapour deposition coat even a very thin film and to handle it in a lamination process. Moreover, such a film may also contribute to stiffness in the final laminated material, despite being very thin.

Even more preferably, the mono-oriented film comprises in the majority various types of low density polyethylenes, preferably linear low density polyethylene (LLDPE).

Preferably, the mono-oriented film has a thickness of 20 µm or below, more preferably 15 µm or below.

Preferably, the step of mono-axially orientating the polymer substrate film is carried out by means of a combined orientating and relaxation method involving at least 10 orientation roller nips, of which the first and the last nips include driven rollers and the rollers there between are non-driven, idle rollers. By this method, stretching and relaxation takes place during the process where the tensions within the film allow and require it, without breaking the web, by help of the idle running stretching rollers. By this method, the speed of the orientation process may also be increased to further increase cost-efficiency of the mono-oriented film substrate.

Preferably, the polymer substrate film is oriented to a ratio of 2-7, preferably from 2-4, more preferably from 2-3 and, preferably, the polymer substrate film then gets an elongation at break lower than 400 %, preferably lower than 300 %, more preferably lower than 200 %.

Thus, Young's modulus varies from about 250-300MPa at an orientation ratio of 2, to up to 700-800 MPa for an orientation ratio of about 6-7. Elongation at break decreases from about 400% to lower than 100% when increasing the ratio from 2 to 7.

Generally, Young's Modulus increases with the orientation ratio, while the elongation at break decreases with the orientation ratio. A good film has been developed at an orientation ratio of about 3, resulting in a film which provides for good elasticity, strength and integrity in a packaging container manufactured from a packaging laminate comprising the film at its innermost side. Using other types and grades of low density polyethylenes, higher orientation ratios may alternatively be preferred.

According to a preferred embodiment, the mono-oriented film comprises a skin layer of a modified polyolefin, or so called adhesive polymer, onto which skin layer the vapour deposition coated barrier layer of a metal compound, inorganic metal compound or carbon-based compound is vapour deposited.

Examples of such modified polyolefins are based on LDPE or LLDPE co-polymers or, preferably, graft co-polymers with functional-group containing monomer units, such as carboxylic or glycidyl functional groups, e.g. (meth)acrylic acid monomers or maleic anhydride (MAH) monomers, (i.e. ethylene acrylic acid copolymer (EAA) or ethylene methacrylic acid copolymer (EMAA)), ethylene-glycidyl(meth)acrylate copolymer (EG(M)A) or MAH-grafted polyethylene (MAH-g-PE). Another example of such modified polymers or adhesive polymers are so called ionomers or ionomer polymers. Preferably, the modified polyolefin is an ethylene acrylic acid copolymer (EAA) or an ethylene methacrylic acid copolymer (EMAA).

The vapour deposited film is bonded to the oxygen gas barrier-coated paper or paperboard layer by an intermediate polymer layer, preferably a thermoplastic polymer layer and more preferably selected from polyolefins and polyolefin-based co-polymers, often known as adhesive polymers, especially LDPE or polyethylene-based polymers or co-polymers, or adhesive polymers.

In order to further improve the light barrier of a packaging laminate according to the invention, if necessary, light absorbing particles or pigments may be blended into the intermediate thermoplastic bonding layer. A preferred example of such light absorbing particles is carbon black. The black colour of the intermediate bonding layer is then advantageously hidden towards the outside by the paperboard layer, and towards the inner side of the laminate, by a metallised, e.g. aluminium, layer.

For thinner low-cost segment packaging laminates, which have a thinner paper core layer, the intermediate thermoplastic bonding layer preferably further comprises inorganic particles in the form of light reflecting, white pigments to improve the light barrier properties of the packaging laminate. Additionally, or alternatively, the substrate polymer film for vapour deposition further comprises inorganic particles in the form of light absorbing, black pigments to improve the light barrier properties of the packaging laminate, preferably carbon black. The black colour- of the innermost light absorbing film, is then advantageously hidden towards the outside by a metallised layer and/ or the white-pigmented intermediate bonding layer.

For higher performance packaging laminates, e.g. requiring longer aseptic shelf life for more sensitive products, it is of course possible to add further barrier layers. One simple way of, for example, increasing further the oxygen barrier properties of the packaging laminate would be to use a thermoplastic bonding layer including a layer of melt-extrudable barrier layer, for the bonding of the vapour deposition coated inside film to the liquid-film barrier coated paperboard to each other. In this way, the only thing to change in order to produce a higher performance packaging laminate, would be to include additional melt extrusion polymer layer(s) in the converting process at the lamination stage (e.g. a further barrier layer and possibly one or two melt co-extrusion tie layers). Everything else would stay the same, regarding raw materials and converting process.

According to a further aspect of the invention, there is provided a packaging container manufactured from the packaging laminate of the invention, having properties such as low oxygen and water vapour permeation rates, package integrity and internal adhesion between laminate layers, which properties are comparable to those of conventional aluminium foil packaging containers, commercially available today for liquid food packaging.

According to yet a further aspect of the invention, there is provided a method for manufacturing of the packaging laminate as defined in independent claim 29.

Thus, the method comprises the steps of providing a core layer of paper or paperboard, providing a liquid gas barrier composition containing a polymer binder dispersed or dissolved in an, aqueous or solvent-based liquid medium, forming a thin oxygen gas barrier layer comprising said polymer binder by coating the liquid composition directly onto a first side of said core layer of paper or paperboard and subsequently drying to evaporate the liquid, laminating a vapour deposited barrier layer- coated film to the inner side of the oxygen gas barrier layer by means of an intermediate polymer layer, providing an innermost layer of a heat sealable polyolefin inside of the vapour deposited barrier layer, the innermost layer optionally being comprised by the polymer substrate film, and providing an outermost layer of a heat sealable polyolefin outside of the core layer.

The liquid gas barrier composition is coated directly onto the inner side of the layer of paper or paperboard. Because the packaged food product is, or contains, a liquid, there is a constant transport of water vapour through the laminate from the inside to the outside, so it is better to allow the water vapour to escape outwards through the liquid film coated layer and continue outwards rather quickly through the paper layer. If the paper layer is coated by a layer of polymer, the water vapour is kept and trapped for a longer time on the inside of the paper layer and raising the relative humidity in the liquid film coated barrier layer. It is thus desirable that the liquid film coated layer is directly adjacent the paper layer.

According to a preferred method of the invention, the oxygen gas barrier layer is applied as two part-layers in two subsequent steps with intermediate drying. When applied as two part-layers, each layer is applied in amounts from 0,1 to 2,5 g/m², preferably from 0,5 to 1 g/m².

According to an embodiment of the invention, the method further comprises the steps of providing a polymer substrate film and vapour depositing a barrier layer onto the polymer substrate film.

Generally, the polymer substrate film for vapour deposition is a thermoplastic polymer film, preferably a polyolefin-based film.

According to a preferred embodiment of the method of the invention, the polymer substrate film for vapour deposition coating is a film which includes the innermost heat sealable layer, and more preferred, the film consists mainly of heat sealable layers. The film according to the invention is preferably manufactured by extrusion film blowing, because of the reliability and cost-efficiency in that process. However, films manufactured by film casting do also fall within the scope of the invention.

According to a most preferred embodiment of the method of the invention, the method further comprises the step of mono-orienting a polymer substrate film for vapour deposition coating of a metal compound, the polymer substrate film comprising in the majority low density polyethylenes.

Preferably, the polymer substrate film, comprising in the majority low density polyethylenes, is mono-oriented to a thickness of 20 µm or less, more preferably 15 µm or less.

According to a preferred embodiment, the polymer substrate film comprises a skin layer of carboxylic group modified polyolefin, such as an ethylene copolymer, or graft copolymer, with acrylic acid or methacrylic acid monomer units, onto which skin layer the metal or inorganic metal compound is vapour deposited. Most preferably, the modified polyolefin is an ethylene acrylic acid copolymer (EAA). Preferably, the skin layer is very thin, i.e. from 0,5 to 5 µm, more preferably from 1 to 3 µm.

Preferably, the layer of the vapour deposited compound has a thickness of from 5 to 500 nm (from 50 to 5000 A).

Preferably, the method of the invention further comprises the step of extrusion laminating the vapour deposited polymer substrate film to the inner side of the oxygen gas barrier layer, by means of an intermediate polymer bonding layer, preferably a thermoplastic polymer bonding layer. The oxygen barrier performance of the liquid film coated oxygen barrier layer is significantly improved when it is coated or laminated to an adjacent layer of, preferably thermoplastic, polymer, and such a layer also contributes to an increased overall abuse resistance of the packaging laminate. In the case of long-term storage and transport of aseptic packaging, it is very important that the packaging container has sufficient strength and abuse resistance for the transport and handling circumstances. Preferably, such intermediate thermoplastic bonding layers are selected among polyolefins and polyolefin-based polymers. In the case of extrusion lamination of an aluminium metal or aluminium oxide coated substrate, the intermediate bonding layer is advantageously a conventional LDPE. The intermediate bonding layer also provides an important contribution to the inside thermoformable bulk of heat sealable polymer materials, which in turn contributes to good quality of the seals in a packaging container. It has been found that a preferable amount of the intermediate polymer bonding layer is from 7 to 20, preferably from 10 to 18 µm.

According to an alternative embodiment, the method instead comprises the further steps of liquid film coating an intermediate, preferably thermoplastic, polymer bonding layer onto the applied oxygen gas barrier layer, a drying step, and subsequent steps of heat-pressure laminating the polymer substrate film coated with the vapour deposited metal compound to the intermediate polymer bonding layer. For such heat-pressure lamination, the intermediate liquid film coated bonding layer is advantageously an adhesive polymer, such as polyolefin-based copolymers or graft copolymers with (meth)acrylic acid or maleic anhydride monomer units. The latter embodiment may advanatageously be used in cases where the thickness of the intermediate polymer bonding layer may be lower and where the requirements on abuse resistance are not so high, e.g. preferably from 2 to 12 µm, preferably from 5 to 10 µm.

### EXAMPLES AND DESCRIPTION OF PREFERRED EMBODIMENTS

In the following, preferred embodiments of the invention will be described with reference to the drawings, of which:
Fig. 1 a and 1 b are schematically showing, in cross-section, first and second embodiments of a packaging laminate produced according to the invention,
Fig. 2a and 2b are showing a method of manufacturing the packaging laminates described in Figures 1 a and 1 b,
Fig. 3 is showing a diagrammatic view of a plant for co-extrusion blowing and subsequent mono-orientation of a preferred substrate polymer film according to the invention,
Fig. 4 is showing a diagrammatic view of a plant for vapour deposition of a preferred metal or metal inorganic compound onto the substrate polymer film produced in Fig.3,
Fig. 5a and 5b are showing examples of packaging containers produced from the packaging laminate according to the invention,
Fig. 6 is showing the principle of how such packaging containers are manufactured from the packaging laminate in a continuous form, fill and seal process,
Fig. 7 shows how a metallised film on the inside of the packaging laminate influences oxygen transmission in a flat packaging laminate and in a finished packaging container,
Fig. 8 shows how a climate with higher humidity influences the oxygen transmission of the flat packaging laminate, and
Fig.9 shows how the oxygen transmission of a packaging laminate according to the invention, having a metallised film on the inside, varies for different grades of paperboard, versus a packaging laminate without the vapour deposited metallised film on the inside.

### EXAMPLE 1

A packaging laminate was produced by liquid film coating of 2 x 1 g/m² of an aqueous gas barrier composition of dissolved and dispersed PVOH and 10 weight-% bentonite clay, calculated on dry matter, in two consecutive steps with drying in between, onto a 320 mN CLC/C paperboard from Frövi.

Preparation of the aqueous gas barrier composition: An aqueous dispersion of from about 1-5 weight-% of exfoliated laminar montmorillonite particles (Kunipia F from Kunimine Kogyo Co.) having an aspect ratio of about 50-5000, is blended with an aqueous solution of about 10 weight-% of PVOH (Mowiol 15-99, having a saponification degree of above 99 %) at 60-90 °C during 1-8 hours. The dispersion of exfoliated laminar mineral particles may be stabilised by means of a stabiliser additive. Alternatively, the laminar mineral particles are exfoliated directly in the PVOH-solution at 60-90 °C during 1-8 hours.

The wet applied coating is then dried at a web surface temperature of 100-150°C.

The paperboard with the liquid film coated gas barrier was creased and then half of the material was coated with a low density polyethylene inside consisting of 25 g/m² LDPE and an innermost layer of 15 g/m² m-LLDPE. The other half of the material was laminated with an aluminium metallised mono-oriented LDPE film, by means of a melt extruded LDPE lamination layer. The mono-oriented film was 18 µm thick. The LDPE lamination layer was about 15 µm thick. The oxygen transmission of the metallised mono-oriented film was measured to about 400 cc /m²/ day/ atm at 23 °C, 80 % RH, which corresponds to about 100 cc/m²/day/atm at 23 °C, 50 % RH.

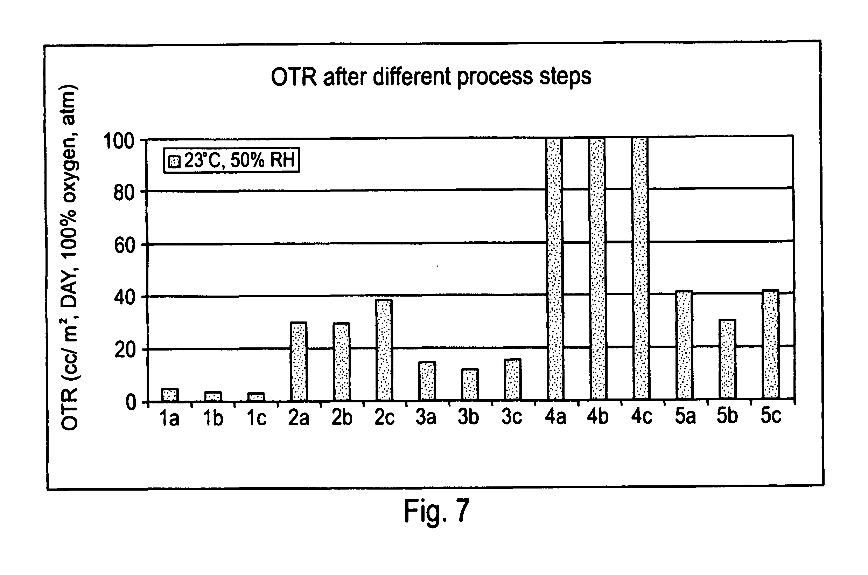

The oxygen transmission was measured on flat laminated packaging material and on a finished packaging container and determined as cc/m²/day/atm (100 % oxygen), calculated from the measured values on a 1-litre package of the Tetra Brik® type. The values obtained are presented in Table 1, and the results are shown in the form of a column chart in Figure 7.

The conclusions are that the improvement between the two packaging laminates is higher than expected. The rather low oxygen barrier level of the metallised layer contributes surprisingly as much as the far better PVOH oxygen barrier layer. Already on the flat packaging laminate the oxygen barrier results are thus surprisingly good. The true surprise comes, however, from the results on finished packages. Whereas the finished packaging container from the laminate with a PE inside structure almost completely loses oxygen barrier properties (the oxygen transmission was around 800 cc/m²/ day, atm, i.e. way outside the limits of the chart in Figure 7), the other packages with a metallised PE-film inside structure only increases oxygen transmission to a controllable level and it seems as though the metallised film inside has repaired and greatly reduced the impact of the damages to the oxygen barrier layer in the creased packaging laminate, on the packaging container.

There has thus been shown a synergy effect in oxygen barrier properties at standard testing climate at 23 °C and 50 % RH. However, when packages are filled with product and stored for a certain time, the barrier layer will eventually reach a higher RH (relative humidity), typically around 80 % RH, at which the performance of the moisture sensitive barrier polymers usually is negatively affected.

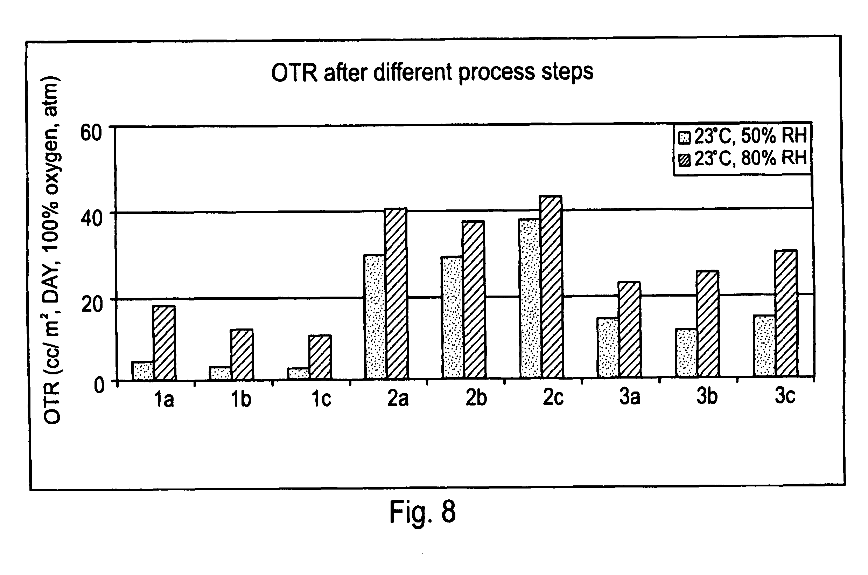

The results presented in Table 2 and Figure 8 (OTR as cc/m²,day,atm, 100 % oxygen), show that the difference in oxygen transmission on un-creased flat packaging laminate, at 23 °C and between 50 % RH and 80 % RH, is about 10 cc/m², day, atm. Although we know that on the creased, flat packaging laminate, there is also oxygen transmission related to the damage caused by creasing, with or without "reparation" by a metallised film, in addition to the original oxygen transmission, the same approximate difference of 10 cc/m², day, atm can be observed between 50 % RH and 80 % RH. From this fact, we can deduce that it is only the contribution in oxygen transmission that comes from the original oxygen transmission, measured on un-creased laminate, which is significantly increased when RH is increased. This increase is related to the sensitivity to RH of the original oxygen transmission measured on un-creased laminate. The contribution in oxygen transmission which is related to the damage and reparation is not sensitive to the change in RH. According to the results below, this means that on a packaging container, the differences in oxygen transmission between a laminate with a PE-inside and a laminate with a met-PE inside are almost the same at 80 % RH as at 50 % RH. Consequently, the synergetic effect is equally valid at 80 % RH. This conclusion could not be checked by factual measurements, because a high humidity laboratory room for oxygen transmission tests was not available, but is confirmed by the fact that good quality aseptic packages were produced, which successfully withstood long-term storage tests under ambient conditions.

Contrary to what was believed from the outset, the quality and oxygen barrier properties of the liquid film coated barrier does not have to be improved further. It seems likely that one may even decrease the oxygen barrier properties of the liquid film coated layer, and still be able to obtain a reliable level of oxygen barrier in the finished packaging container, by combining with a film coated with a thin vapour deposited metal or inorganic metal compound. It is highly surprising that two such thin and rather brittle and abuse-sensitive layers, can be combined to provide a robust packaging laminate for aseptic, ambient packaging, having comparable properties to packaging laminates based on aluminium foil, for a period of at least 3 months.

Still, there are of course possibilities to further increase the gas barrier properties a little by coating thicker layers of the gas barrier composition, or to fill the PVOH layer with higher amount of inorganic particles. There is, however, a more significant gain in odour barrier properties, by coating a thicker and more densely filled gas barrier layer composition. An excellent example of such a barrier composition comprises PVOH and from 10 to 50, preferably from 20 to 40 weight-% of talcum particles.

The oxygen transmission values were measured on packaging material by a Mocon Oxtran 2/20 equipment. Air was used as test-gas, as the packaging material structures included paperboard. All oxygen transmission values are therefore multiplied by a factor of 4,76. Preconditioning was done for at least a week (in lab at 23 °C and 50% RH, in climate chamber at 23 °C and 80 % RH) and further by continuing the measurements in the equipment until stable values were seen. For statistical evaluation, six samples were measured. The average value from three measurements are presented in Table 1.

**Table 1**

| | Flat uncreased material | | Creased material | | Packaging container |
|---|---|---|---|---|---|
| | 50% RH | 80% RH | 50% RH | 80% RH | 50% RH |
| PE inside | 3,7 | 13,6 | 32,2 | 40,5 | 842 |
| Met-PE inside | -- | -- | 13,5 | 26 | 37,3 |

**Table 2**

| | | OTR at 23C/ 50%RH | | OTR at 23C/ 80% RH [cc/m², day, atm] | | |
|---|---|---|---|---|---|---|
| | | [cc/m², day, atm] | (cc/m², day, atm) | | | |
| | | X+Y | Delta | X+Y | X | Y |
| | | Total OTR | Diff.50% to 80% RH | Total OTR | Contribution from original pack mat | Contribution from losses and "repair" |
| Uncreased packaging material | PE-inside | 4 | Δ = 10 | 14 | 14 | 0 |
| Creased packaging material | PE-inside | 32 | Δ = 8 | 40 | 14 * | 26 * 40-14 |
| | MetPE-inside | 14 | Δ = 12 | 26 | 14 * | 12 * 26-14 |
| Package (recalculated to cc/sqm) | PE-inside | 842 | Δ ∼ 10 * | 852 * | 14 * | 838 * 852-14 |
| | MetPE-inside | 37 | Δ ∼10 * | 47 * | 14 * | 33 * 47-14 |

| | | | | | | |
|---|---|---|---|---|---|---|
| * estimated value | | | | | | |

### Example 2

In a different experiment, it was seen that when coating the same liquid gas barrier composition onto different paperboard grades, greatly varied results in oxygen transmission were obtained. It has not been fully understood why the different paperboards gave rise to the different results in oxygen barrier. The different paperboards were coated as above by 2 x 1 g/m² of PVOH with montmorillonite and then further laminated with a PE inside or with a metallised PE-film, respectively, as described above. The oxygen transmission on flat packaging laminate was measured at 23 °C and 50% RH. The following paperboards were coated (numbered from 1 to 8):
1. Frövi 260 mN
2. Frövi 320 mN
3. Korsnäs 260 mN
4. Korsnäs 150 mN
5. Korsnäs 80 mN
6. Stora Enso 260 mN
7. International Paper 260 mN
8. Klabin 260 mN

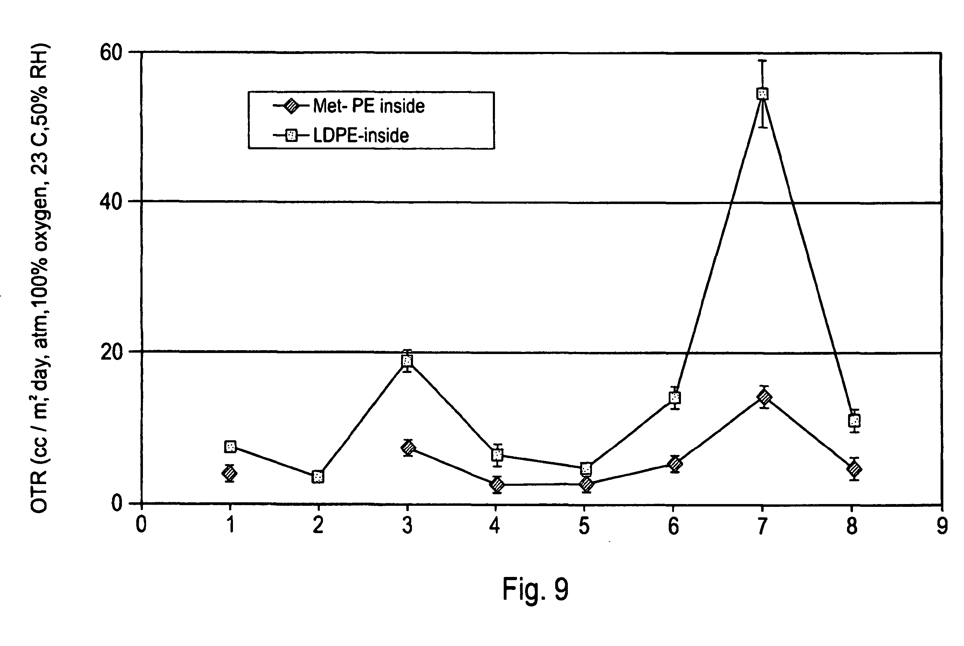

As can be seen in the diagram of Figure 9, the differences in oxygen transmission values (cc/m2, day, atm 100 % oxygen, 23 °C, 50% RH) are evened out by the addition of the metallised film to the packaging laminate (Met-PE-inside versus LDPE-inside). Consequently, it seems that also in this case, the film, vapour deposited with a metal compound, evens out and repairs some kind of defects in the oxygen barrier, arising from some differing properties of the paperboard.

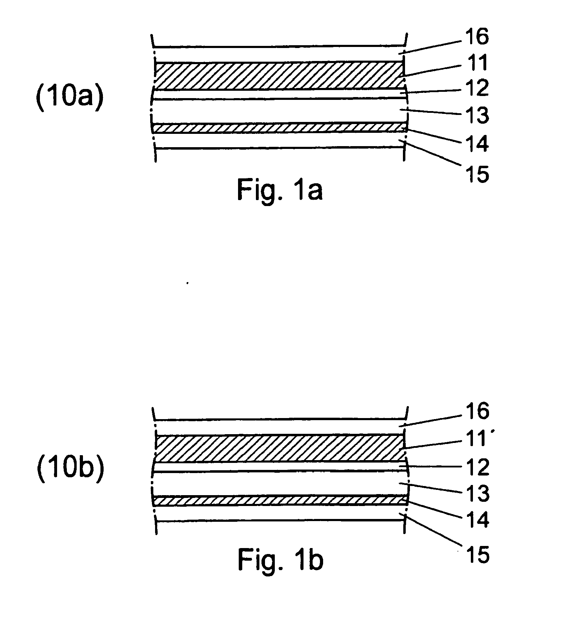

In Fig. 1a, there is shown, in cross-section, a first embodiment of a packaging laminate 10a for aseptic packaging and long-term storage under ambient conditions, produced according to the invention. The laminate comprises a paperboard core layer 11, having a bending force of 320 mN, and a thin oxygen gas barrier layer 12 formed by liquid film coating of a liquid gas barrier composition, and subsequent drying, onto the paperboard layer 11. The oxygen gas barrier composition comprises an aqueous solution of PVOH and a dispersion of inorganic laminar particles, in particular exfoliated bentonite clay at 10 weight-% based on dry weight, and after drying, the coated layer thus comprises PVOH with the flake-formed or laminar particles distributed in a layered manner within the PVOH matrix or continuous phase. The packaging laminate further comprises a polymer substrate film 15, coated with a thin vapour deposited layer of aluminium metal at a thickness of from 10 to 30 nm. The vapour deposition coated polymer film 15-14 is laminated to the liquid film coated core layer 11-12, by an intermediate layer 13 of a polyolefin-based polymer, preferably a low density polyethylene (LDPE). The intermediate bonding layer 13 is preferably formed by means of extrusion laminating the oxygen barrier coated core layer and the vapour deposited substrate film to each other. The thickness of the intermediate bonding layer 13 is then preferably from 7 to 20 µm, more preferably from 12-18 µm. An outer liquid tight and heat sealable layer 16 of polyolefin is applied on the outside of the core layer 11, which side is to be directed towards the outside of a packaging container produced from the packaging laminate. The polyolefin of the outer layer 16 is a conventional low density polyethylene (LDPE) of a heat sealable quality. An innermost liquid tight and heat sealable layer 15 is arranged on the inside of the vapour deposited layer 14, which is to be directed towards the inside of a packaging container produced from the packaging laminate, and the layer 15 will be in contact with the packaged product. The innermost heat sealable layer comprises linear low density polyethylene (LLDPE), preferably including also an LLDPE produced by polymerising an ethylene monomer with a C4-C8, more preferably a C6-C8, alpha-olefin alkylene monomer in the presence of a metallocene catalyst, i.e. a so called metallocene - LLDPE (m-LLDPE). The innermost heat sealable layer 15 may consist of two or several part-layers of the same or different kinds of LLDPE and thus constitutes the polymer substrate film 15. The polymer substrate film 15 is mono-oriented to a thickness of 20 µm or below, preferably from 15 µm to 20 µm, and has a thin metal-receiving skin layer of an ethylene acrylic acid copolymer (EAA). The thickness of the metal-receiving layer is from 1 to 3 µm. In special cases, where a thicker heat sealable layer is needed, it is of course possible, although not preferred from a cost perspective, to apply a further heat sealable polyethylene layer onto the inside of the innermost layer 15.

Fig. 1b shows the same packaging laminate as described in Fig. 1a, with the difference that the paper core layer 11' is a thinner paper layer of about 70 g/m². Since the paper layer is much thinner, this packaging laminate needs an additional light barrier by added pigments in the thermoplastic layers. Thus, there are light reflecting white pigments, such as for example titanium dioxide (TiO2) added to the intermediate bonding layer 13. In addition, black light absorbing pigments may be added in the polymer substrate film.

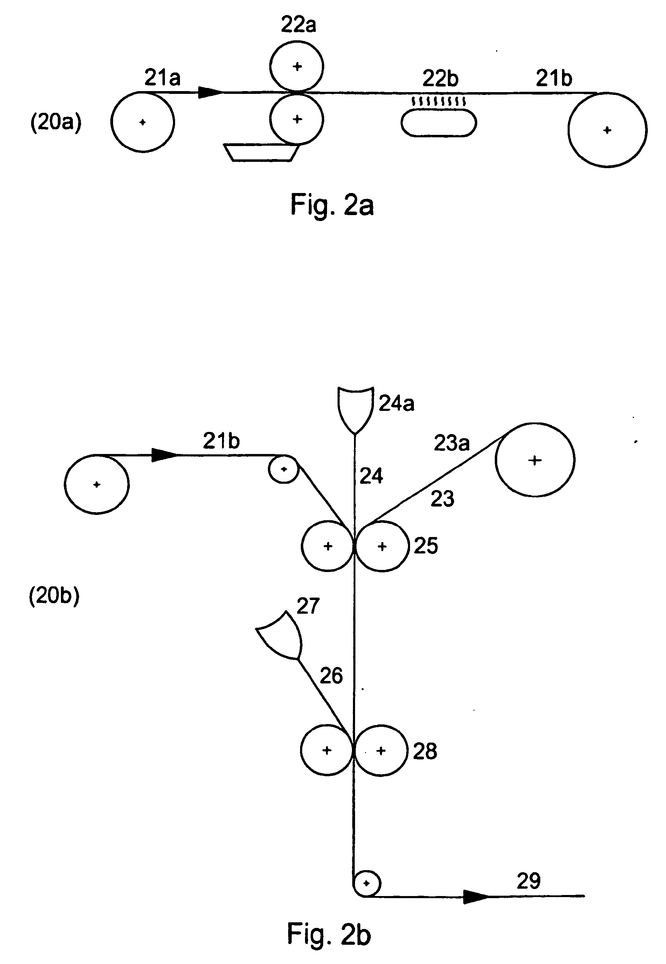

In Fig. 2a, the method of liquid film coating of the liquid oxygen barrier composition onto the paper or paperboard layer is diagrammatically shown. The paper layer 21 a is fed from a storage reel towards a liquid film coating station 22a, where the liquid gas barrier composition is applied at an amount such that the amount of coated and dried layer is about 1-2 g/m², when the coated paper has passed the drying station 22b. Preferably, the liquid film coating operation is carried out in two steps, i.e. by first coating 0,5-1 g/m², drying in an intermediate step and then coating a second time at 0,5-1 g/m² and finally drying the total liquid film coated layer to obtain an oxygen barrier coated paper layer 21 b.

In Fig. 2b, the lamination process 20b is shown, wherein the oxygen barrier coated layer 21 b is laminated to a vapour deposited substrate polymer film 23, having a thin vapour deposited coating 23a on the side facing towards the paper layer, by extruding an intermediate bonding layer of LDPE 24 from an extrusion station 24a and pressing together in a roller nip 25. In the case of a metallised vapour deposition coating, the contacting surface of the substrate film, or of the receiving layer, is pre-treated by a surface treatment (not shown) before pressing the layers together in the nip. Subsequently, the laminated paper and film passes a second extruder 27 and lamination nip 28, where an outermost heat sealable layer of LDPE 26 is coated onto the outer side of the paper layer. Finally, the finished packaging laminate 29 is wound onto a storage reel, not shown.

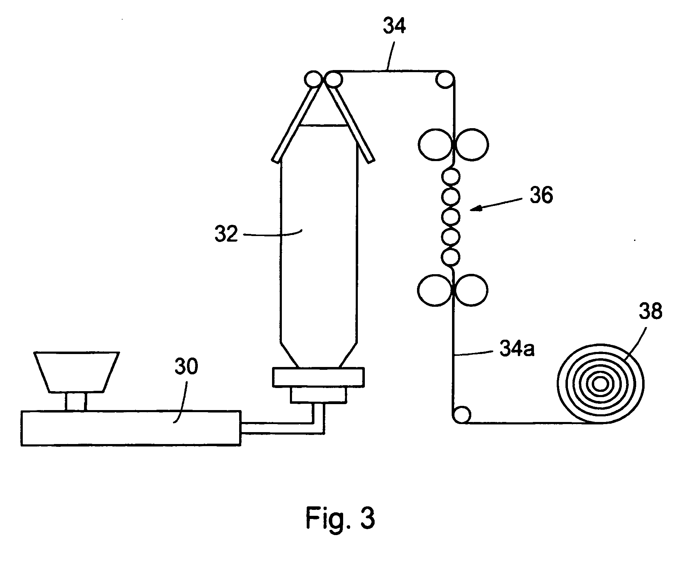

Fig. 3 is a diagrammatic view of a plant for (co-)extrusion blowing of an intermediate film, i.e. the substrate polymer film before being vapour deposition coated by a metal or by an inorganic metal compound. The one or more layers of the substrate polymer film are (co-)extruded from the extruder 30 and blown 32, to form a film 34 of relatively high thickness. Then, the film 34 is subjected to mono-axial orientation 36 between rollers, while it is hot, such that the thickness of the film is reduced 34a and the substrate polymer film becomes mono-oriented and gets a certain degree of stiffness due to a relatively higher degree of crystallinity than non-oriented polymer films. The resulting intermediate film is then optionally heat stabilised in an additional heating step before it is wound to a roll 38. The temperature profile through the set of rollers is optimised for orientating the specific structure of the film to avoid curling or breaking of the web. The film 34 has the form of a tube, when it exits the extrusion-blower 32, and may be opened/slit before being orientated. If necessary, two parallel orienters 36 may be used in that case. It is also possible to perform the orientating operation off-line from the film blower.

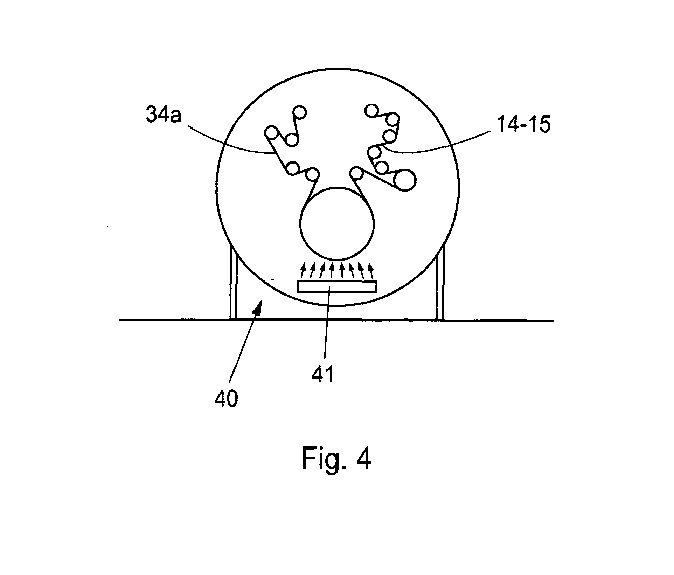

Fig. 4, is a diagrammatic view of an example of a plant for vapour deposition coating of the intermediate film produced in Fig. 3. The orientated film 34a from Fig. 3 is subjected, on the coating receiving side, to continuous evaporation deposition 40, of a metallised layer of aluminium, possibly in a mixture with aluminium oxide, and the coating is given a thickness of 5-100 nm, preferably 5-50 nm, so that the coated film 14-15 of the invention is formed. The aluminium vapour comes from a solid piece evaporation source 41.

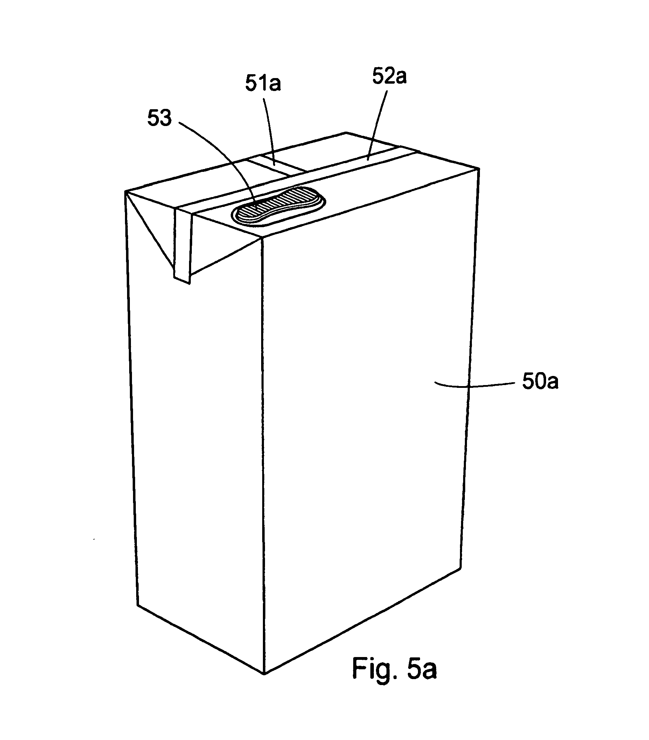

Fig. 5a shows a preferred example of a packaging container 50 produced from the packaging laminate 10a according to the invention. The packaging container is particularly suitable for beverages, sauces, soups or the like. Typically, such a package has a volume of about 100 to 1000 ml. It may be of any configuration, but is preferably brick-shaped, having longitudinal and transversal seals 51 a and 52a, respectively, and optionally an opening device 53. In another embodiment, not shown, the packaging container may be shaped as a wedge. In order to obtain such a "wedge-shape", only the bottom part of the package is fold formed such that the transversal heat seal of the bottom is hidden under the triangular corner flaps, which are folded and sealed against the bottom of the package. The top section transversal seal is left unfolded. In this way the half-folded packaging container is still is easy to handle and dimensionally stable when put on a shelf in the food store or on a table or the like.

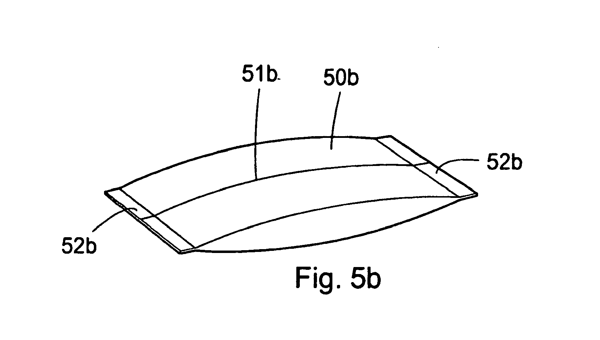

Fig. 5b shows an alternative, preferred example of a packaging container 50b produced from the packaging laminate 10b according to the invention. Since the packaging laminate 10b is thinner by having a thinner paper core layer, it is not dimensionally stable enough to form a parallellepipedic or wedge-shaped packaging container, and is not fold formed after transversal sealing 52b. It will thus remain a pillow-shaped pouch-like container and be distributed and sold like this.

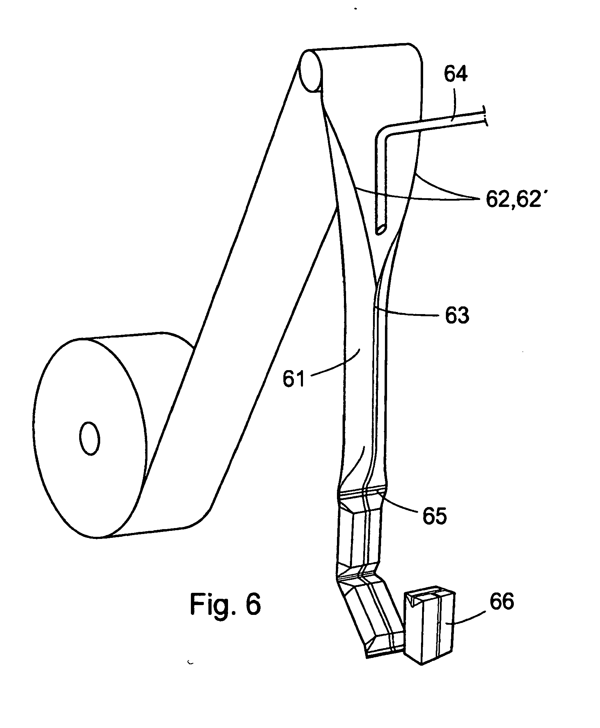

Fig. 6 shows the principle as described in the introduction of the present application, i.e. a web of packaging material is formed into a tube 61 by the longitudinal edges 62, 62' of the web being united to one another in an overlap joint 63. The tube is filled 64 with the intended liquid food product and is divided into individual packages by repeated transversal seals 65 of the tube at a predetermined distance from one another below the level of the filled contents in the tube. The packages 66 are separated by incisions in the transversal seals and are given the desired geometric configuration by fold formation along prepared crease lines in the material.

The invention is not limited by the embodiments shown and described above, but may be varied within the scope of the claims.

### Legend to Fig. 7 and Fig. 8: "OTR after different process steps"

1 a: C97 (uncreased)
1 b: C107 (uncreased)
1c: C121 (uncreased)
2a: C97 (creased, PE-inside)
2b: C107 (creased, PE-inside)
2c: C121 (creased, PE-inside)
3a: C97 (creased, met PE-inside)
3b: C107 (creased, met PE-inside)
3c: C121 (creased, met PE-inside)
4a: C97 (package, PE-inside)
4b: C107 (package, PE-inside)
4c: C121 (package, PE-inside)
5a: C97 (package, met PE-inside)
5b: C107 (package, met PE-inside)
5c: C121 (package, met PE-inside)

## Claims

1. Packaging laminate (10a; 10b) having gas barrier properties, for packaging of a liquid food product, comprising a core layer (11; 11') of paper or paperboard, a first outermost liquid tight, heat sealable polyolefin layer (16), a second innermost liquid tight, heat sealable polyolefin layer (15) and, coated directly onto and adjacent the inner side of the core layer (11; 11') of paper or paperboard, an oxygen gas barrier layer (12) formed by liquid film coating of a liquid gas barrier composition and subsequent drying, the liquid composition containing a polymer binder dispersed or dissolved in an aqueous or solvent medium, wherein the packaging laminate further comprises a vapour deposited barrier layer (14) coated onto a polymer substrate film, which polymer substrate film optionally comprises the innermost heat sealable polyolefin layer (15), wherein the vapour deposited barrier layer (14) is arranged between said oxygen gas barrier layer (12) and said innermost heat sealable polyolefin layer (15), and wherein the vapour deposited barrier layer-coated film (14-15) is bonded to the oxygen gas barrier-coated core layer (11-12) by an intermediate polymer layer (13).

2. Packaging laminate for liquid food packaging according to claim 1, **characterised in that** said oxygen gas barrier layer includes from 60 to 99 weight-% of said polymer binder, based on the dry coating weight.

3. Packaging laminate for liquid food packaging according to any one of claims 1 or 2, **characterised in that** said polymer binder is a polymer having gas barrier properties.

4. Packaging laminate for liquid food packaging according to any one of claims 1-3, **characterised in that** said polymer binder is selected from the group consisting of vinyl alcohol-based polymers, such as preferably PVOH or water dispersible EVOH, and acrylic acid or methacrylic acid polymers, polysaccharides, polysaccharide derivatives and combinations of two or more thereof.

5. Packaging laminate for liquid food packaging according to any one of claims 1 or 2, **characterised in that** said polymer binder is PVOH, preferably having a saponification degree of at least 98 %, more preferably of at least 99 %.

6. Packaging laminate according to any one of claims 1-5, **characterised in that** said liquid composition further comprises inorganic particles.

7. Packaging laminate according to claim 6, **characterised in that** said inorganic particles are laminar in shape.

8. Packaging laminate according to claim 7, **characterised in that** said inorganic particles mainly consist of laminar nano-sized clay particles having an aspect ratio of from 50 to 5000.

9. Packaging laminate according to claim 8, **characterised in that** said inorganic particles are dispersed to an exfoliated state.

10. Packaging laminate according to any one of claims 7-9, **characterised in that** said inorganic particles are montmorillonite.

11. Packaging laminate according to claim 7, **characterised in that** said inorganic particles mainly consist of laminar talcum particles having an aspect ratio of from 10 to 500.

12. Packaging laminate according to any one of claims 1-11, **characterised in that** said oxygen gas barrier layer (12) is applied at a total amount of from 0,1 to 5 g/m², preferably from 0,5 to 3,5 g/m², more preferably 0,5 to 2 g/m², dry weight.

13. Packaging laminate according to any one of the preceding claims, **characterised in that** said oxygen gas barrier layer (12) is appl ied in two or more subsequent steps with intermediate drying, as two or more part-layers, at an amount of from 0,5 to 2 g/m² each, preferably from 0,5 to 1 g/m² each.

14. Packaging laminate according to any one of the preceding claims, **characterised in that** the vapour deposited barrier layer (14) is a metal or inorganic metal compound.

15. Packaging laminate according to any one of the preceding claims, **characterised in that** the vapour deposited barrier layer (14) is a layer substantially consisting of aluminium or aluminium oxide.

16. Packaging laminate according to any one of Claims 1 to 13, **characterised in that** the vapour deposited barrier layer (14) is a carbon-based layer.

17. Packaging laminate according to any one of the preceding claims, **characterised in that** the vapour deposited barrier layer (14) is applied at a thickness of from 5 to 200 nm (from 50 to 2000 A).

18. Packaging laminate according to any one of the preceding claims, **characterised in that** the polymer substrate film for vapour deposition is a polyolefin-based film.

19. Packaging laminate according to any one of the preceding claims, **characterised in that** the polymer substrate film for vapour deposition also comprises said innermost heat sealable polyolefin layer (15).

20. Packaging laminate according to any one of the preceding claims, **characterised in that** said innermost heat sealable polyolefin layer (15) mainly consists of low density polyethylene, and preferably mainly consists of linear low density polyethylene (LLDPE).

21. Packaging laminate according to any one of claims18-20, **characterised in that** said polymer substrate film is a mono-oriented film (34a) consisting of said innermost heat sealable polyolefin layer (15).

22. Packaging laminate according to claim 21, **characterised in that** said mono-oriented film (15; 34a) comprises in the majority low density polyethylene, preferably linear low density polyethylene.

23. Packaging laminate according to any one of claims 21 and 22, **characterised in that** said mono-oriented film (15) has a thickness of 20 µm or below, preferably 15 µm or below.

24. Packaging laminate according to any one of claims 21-23, **characterised in that** the mono-oriented film (15) comprises a skin layer of polyolefin modified with functional groups, onto which skin layer the vapour deposited barrier layer (14) is applied.

25. Packaging laminate according to claim 24, **characterised in that** the modified polyolefin is an ethylene (meth)acrylic acid copolymer (EAA or EMAA).

26. Packaging laminate according to any one of the preceding claims, **characterised in that** said vapour deposited barrier layer-coated film (14-15) is bonded to the paper or paperboard core layer (11, 11') by an intermediate polymer layer (13) selected from polyolefins and polyolefin-based adhesive polymers.

27. Packaging laminate according to claim 26, **characterised in that** the intermediate polymer layer (13) further comprises inorganic particles in the form of black pigments to improve the light barrier properties of the packaging laminate.

28. Packaging laminate according to claim 26, **characterised in that** the intermediate polymer layer (13) further comprises inorganic particles in the form of white pigments to improve the light barrier properties of the packaging laminate.

29. Method of manufacturing a packaging laminate (10a; 10b; 29) according to any one of claims 1-28, comprising the steps of
- providing a core layer of paper or paperboard (11; 11'; 21 a),
- providing a liquid gas barrier composition containing a polymer binder dispersed or dissolved in an aqueous or solvent-based liquid medium,
- forming a thin oxygen gas barrier layer (12) comprising said polymer binder by coating (22a) the liquid composition directly onto a first side of said core layer of paper or paperboard (11; 11'; 21 a) and subsequently drying (22b) to evaporate the liquid,
- laminating a vapour deposited barrier layer-coated polymer substrate film (23; 23a) to the inner side of the oxygen gas barrier layer (12) by means of an intermediate polymer layer (13; 24),
- providing an innermost layer (15) of a heat sealable polyolefin inside of the vapour deposited barrier layer (14), the innermost layer (15) optionally being comprised by the polymer substrate film (23) and
- providing an outermost layer (16; 26) of a heat sealable polyolefin outside of the core layer (11; 21 a).

30. Method according to claim 29, wherein the liquid gas barrier composition further contains inorganic particles.

31. Method according to any one of claims 29-30, wherein the oxygen gas barrier polymer contained in the liquid composition is selected from a group consisting of PVOH, water-dispersible EVOH, acrylic or methacrylic acid polymers, polysaccharides, polysaccharide derivatives and combinations of two or more thereof.

32. Method according to any one of claims 29-31, wherein the oxygen gas barrier layer (12) is applied in a total amount of from 0,1 to 5 g/m², preferably from 0,5 to 3,5 g/m², more preferably from 0,5 to 2 g/m², dry weight.

33. Method according to any one of claims 29-32, wherein the oxygen gas barrier layer (12) is applied as two or more part-layers in two or more subsequent steps with intermediate drying, at an amount of from 0,5 to 2 g/m² each, preferably from 0,5 to 1 g/m² each.

34. Method according to any one of claims 29-33, further comprising the steps of
- providing a polymer substrate film (23) and
- vapour depositing a barrier layer (14;23a) onto the polymer substrate (23) film.

35. Method according to any one of claims 29-34, wherein the polymer substrate film (34a) for vapour deposition is produced by extrusion blowing (32) of a film, which includes the innermost heat sealable polymer layer (15; 23).

36. Method according to claim 35, further comprising the step of mono-orienting (36) the blown polymer substrate film (34) before vapour deposition coating, the polymer substrate film (34a) comprising in the majority linear low density polyethylene.

37. Method according to claim 36, wherein the polymer substrate film (23; 34a), comprising in the majority the linear low density polyethylene, is mono-oriented (36) to a thickness of 20 µm or below, preferably 15 µm or below.

38. Method according to any one of claims 29-37, wherein a layer of aluminium metal or aluminium oxide (14; 23a) is vapour deposited (40) onto the polymer substrate film (23; 34a; 44a).

39. Method according to any one of claims 29-38, wherein the vapour deposited barrier layer (14; 23a) is applied at a thickness of from 5 to 200 nm (from 50 to 2000 A).

40. Method according to any one of claims 29-39, wherein the vapour deposition barrier layer-coated film (14-15; 23-23a) is laminated to the inner side of the oxygen gas barrier layer (12), by means of extrusion laminating with an intermediate polymer layer (13; 24).

41. Method according to any one of claims 29-39, wherein the intermediate polymer layer (13; 24) is a thermoplastic bonding layer and the vapour deposited barrier layer (14; 23a) is of a metal compound, further comprising the steps of liquid film coating the intermediate polymer layer (13) onto the applied oxygen gas barrier layer (12), drying, and subsequently heat-pressure laminating the vapour deposition barrier layer-coated film (14-15; 23-23a) to the intermediate polymer layer (13).

42. Packaging container (50a; 50b) manufactured from the packaging laminate (10a; 10b) as specified in any one of claims 1-28.

## Patentansprüche

1. Verpackungslaminat (10a; 10b) mit Gasbarriere-Eigenschaften zum Verpacken eines flüssigen Lebensmittelprodukts, umfassend eine Kernschicht (11; 11') aus Papier oder Pappe, eine erste, äußerste, flüssigkeitsdichte, heißsiegelfähige Polyolefinschicht (16), eine zweite, innerste flüssigkeitsdichte, heißsiegelfähige Polyolefinschicht (15) und direkt auf die Innenseite der Kernschicht (11; 11') aus Papier oder Pappe geschichtet und daran angrenzend eine Sauerstoffgas-Barriereschicht (12), gebildet durch Flüssigkeitsfilm-Beschichten einer flüssigen Gasbarriere-Zusammensetzung und anschließendes Trocknen, wobei die flüssige Zusammensetzung ein Polymer-Bindemittel enthält, das in einem wässrigen Medium oder Lösungsmittelmedium dispergiert oder gelöst ist, wobei das Verpackungslaminat ferner eine aufgedampfte Barriereschicht (14) umfasst, die auf einen Polymersubstratfilm geschichtet ist, wobei der Polymersubstratfilm gegebenenfalls die innerste, heißsiegelfähige Polyolefinschicht (15) umfasst, wobei die aufgedampfte Barriereschicht (14) zwischen der Sauerstoffgas-Barriereschicht (12) und der innersten heißsiegelfähigen Polyolefinschicht (15) angeordnet ist, und wobei der aufgedampfte Barriereschicht-beschichtete Film (14-15) durch eine Polymer-Zwischenschicht (13) an die Sauerstoffgas-Barrierebeschichtete Kernschicht (11-12) gebunden ist.

2. Verpackungslaminat zum Verpacken flüssiger Lebensmittel, gemäß Anspruch 1, **dadurch gekennzeichnet, dass** die Sauerstoffgas-Barriereschicht 60 bis 99 Gew.-% des PolymerBindemittels, bezogen auf das Beschichtungstrockengewicht, enthält.

3. Verpackungslaminat zum Verpacken flüssiger Lebensmittel gemäß einem der Ansprüche 1 oder 2, **dadurch gekennzeichnet, dass** das Polymer-Bindemittel ein Polymer mit Gasbarriere-Eigenschaften ist.

4. Verpackungslaminat zum Verpacken flüssiger Lebensmittel gemäß einem der Ansprüche 1-3, **dadurch gekennzeichnet, dass** das Polymer-Bindemittel ausgewählt ist aus der Gruppe bestehend aus Polymeren auf Vinylalkohol-Basis, wie z. B. vorzugsweise PVOH oder wasserdispergierbares EVOH, und Acrylsäure- oder Methacrylsäure-Polymeren, Polysacchariden, Polysaccharid-Derivaten und Kombinationen von zwei oder mehreren davon.

5. Verpackungslaminat zum Verpacken flüssiger Lebensmittel gemäß einem der Ansprüche 1 oder 2, **dadurch gekennzeichnet, dass** das Polymer-Bindemittel PVOH ist, vorzugsweise mit einem Verseifungsgrad von wenigstens 98 %, bevorzugter wenigstens 99 %.

6. Verpackungslaminat gemäß einem der Ansprüche 1-5, **dadurch gekennzeichnet, dass** die flüssige Zusammensetzung ferner anorganische Partikel umfasst.

7. Verpackungslaminat gemäß Anspruch 6, **dadurch gekennzeichnet, dass** die anorganischen Partikel laminar geformt sind.

8. Verpackungslaminat gemäß Anspruch 7, **dadurch gekennzeichnet, dass** die anorganischen Partikel hauptsächlich aus laminaren, nanometergroßen Tonpartikeln mit einem Aspektverhältnis von 50 bis 5000 bestehen.

9. Verpackungslaminat gemäß Anspruch 8, **dadurch gekennzeichnet, dass** die anorganischen Partikel zu einem exfolierten Zustand dispergiert sind.

10. Verpackungslaminat gemäß einem der Ansprüche 7-9, **dadurch gekennzeichnet, dass** es sich bei den anorganischen Partikeln um Montmorillonit handelt.

11. Verpackungslaminat gemäß Anspruch 7, **dadurch gekennzeichnet, dass** die anorganischen Partikel hauptsächlich aus laminaren Talkumpartikeln mit einem Aspektverhältnis von 10 bis 500 bestehen.

12. Verpackungslaminat gemäß einem der Ansprüche 1-11, **dadurch gekennzeichnet, dass** die Sauerstoffgas-Barriereschicht (12) in einer Gesamtmenge von 0,1 1 bis 5 g/m² Trockengewicht, vorzugsweise von 0,5 bis 3,5 g/m², bevorzugter von 0,5 bis 2 g/m², aufgebracht ist.

13. Verpackungslaminat gemäß einem der vorstehenden Ansprüche, **dadurch gekennzeichnet, dass** die Sauerstoffgas-Barriereschicht (12) in zwei oder mehr aufeinanderfolgenden Schritten mit dazwischenliegendem Trocknen als zwei oder mehr Teilschichten in einer Menge von jeweils 0,5 bis 2 g/m², bevorzugter jeweils 0,5 bis 1 g/m², aufgebracht ist.

14. Verpackungslaminat gemäß einem der vorstehenden Ansprüche, **dadurch gekennzeichnet, dass** die aufgedampfte Barriereschicht (14) ein Metall oder eine anorganische Metallverbindung ist.

15. Verpackungslaminat gemäß einem der vorstehenden Ansprüche, **dadurch gekennzeichnet, dass** die aufgedampfte Barriereschicht (14) eine Schicht ist, die im Wesentlichen aus Aluminium oder Aluminiumoxid besteht.

16. Verpackungslaminat gemäß einem der Ansprüche 1 bis 13, **dadurch gekennzeichnet, dass** die aufgedampfte Barriereschicht (14) eine Schicht auf Kohlenstoffbasis ist.

17. Verpackungslaminat gemäß einem der vorstehenden Ansprüche, **dadurch gekennzeichnet, dass** die aufgedampfte Barriereschicht (14) mit einer Dicke von 5 bis 200 nm (von 50 bis 2000 Å) aufgebracht ist.

18. Verpackungslaminat gemäß einem der vorstehenden Ansprüche, **dadurch gekennzeichnet, dass** der Polymersubstratfilm für das Aufdampfen ein Film auf Polyolefinbasis ist.

19. Verpackungslaminat gemäß einem der vorstehenden Ansprüche, **dadurch gekennzeichnet, dass** der Polymersubstratfilm für das Aufdampfen auch die innerste heißsiegelfähige Polyolefinschicht (15) umfasst.

20. Verpackungslaminat gemäß einem der vorstehenden Ansprüche, **dadurch gekennzeichnet, dass** die innerste heißsiegelfähige Polyolefinschicht (15) hauptsächlich aus Polyethylen mit niedriger Dichte besteht, und vorzugsweise hauptsächlich aus linearem Polyethylen mit niedriger Dichte (LLDPE) besteht.

21. Verpackungslaminat gemäß einem der Ansprüche 18-20, **dadurch gekennzeichnet, dass** der Polymersubstratfilm ein monoorientierter Film (34a) ist, der aus der innersten heißsiegelfähigen Polyolefinschicht (15) besteht.

22. Verpackungslaminat gemäß Anspruch 21, **dadurch gekennzeichnet, dass** der monoorientierte Film (15; 34a) hauptsächlich Polyethylen niedriger Dichte umfasst, vorzugsweise lineares Polyethylen mit niedriger Dichte.

23. Verpackungslaminat gemäß einem der Ansprüche 21 und 22, **dadurch gekennzeichnet, dass** der monoorientierte Film (15) eine Dicke von 20 µm oder weniger aufweist, vorzugsweise 15 µm oder weniger.

24. Verpackungslaminat gemäß einem der Ansprüche 21-23, **dadurch gekennzeichnet, dass** der monoorientierte Film (15) eine Hautschicht aus Polyolefin, das mit funktionellen Gruppen modifiziert ist, umfasst, auf welche Hautschicht die aufgedampfte Barriereschicht (14) aufgebracht ist.

25. Verpackungslaminat gemäß Anspruch 24, **dadurch gekennzeichnet, dass** das modifizierte Polyolefin ein Ethylen-(Meth)acrylsäure-Copolymer (EAA oder EMAA) ist.

26. Verpackungslaminat gemäß einem der vorstehenden Ansprüche, **dadurch gekennzeichnet, dass** der aufgedampfte Barriereschicht-beschichtete Film (14-15) durch eine Polymer-Zwischenschicht (13), ausgewählt aus Polyolefinen und Klebstoffpolymeren auf Polyolefinbasis, an die Papier- oder Pappkernschicht (11; 11') gebunden ist.

27. Verpackungslaminat gemäß Anspruch 26, **dadurch gekennzeichnet, dass** die Polymer-Zwischenschicht (13) ferner anorganische Partikel in der Form von schwarzen Pigmenten umfasst, um die Lichtbarriere-Eigenschaften des Verpackungslaminats zu verbessern.

28. Verpackungslaminat gemäß Anspruch 26, **dadurch gekennzeichnet, dass** die Polymer-Zwischenschicht (13) ferner anorganische Partikel in der Form von weißen Pigmenten umfasst, um die Lichtbarriere-Eigenschaften des Verpackungslaminats zu verbessern.

29. Verfahren zum Herstellen eines Verpackungslaminats (10a; 10b; 29) gemäß einem der Ansprüche 1-28, umfassend folgende Schritte
- Bereitstellen einer Kernschicht aus Papier oder Pappe (11; 11'; 21a),
- Bereitstellen einer flüssigen Gasbarriere-Zusammensetzung, die ein Polymer-Bindemittel enthält, das in einem wässrigen oder lösungsmittelbasierenden flüssigen Medium dispergiert oder gelöst ist,
- Bilden einer dünnen Sauerstoffgas-Barriereschicht (12), umfassend das Polymer-Bindemittel, durch Aufbringen (22a) der flüssigen Zusammensetzung direkt auf eine erste Seite der Kernschicht aus Papier oder Pappe (11; 11'; 21a) und anschließend Trocknen (22b), um die Flüssigkeit abzudampfen,
- Laminieren eines aufgedampften Barriereschicht-beschichteten Polymersubstratfilms (23; 23a) auf die Innenseite der Sauerstoffgas-Barriereschicht (12) mithilfe einer Polymer-Zwischenschicht (13; 24),
- Bereitstellen einer innersten Schicht (15) aus einem heißsiegelfähigen Polyolefin innen bezogen auf die aufgedampfte Barriereschicht (14), wobei die innerste Schicht (15) gegebenenfalls von dem Polymersubstratfilm (23) umfasst ist, und
- Bereitstellen einer äußersten Schicht (16; 26) aus einem heißsiegelfähigen Polyolefin außerhalb der Kernschicht (11; 21a).

30. Verfahren gemäß Anspruch 29, wobei die flüssige Gasbarriere-Zusammensetzung ferner anorganische Partikel umfasst.

31. Verfahren gemäß einem der Ansprüche 29-30, wobei das Sauerstoffgas-Barrierepolymer, das in der flüssigen Zusammensetzung enthalten ist, ausgewählt ist aus der Gruppe bestehend aus PVOH, wasserdispergierbarem EVOH, Acrylsäure- oder Methacrylsäure-Polymeren, Polysacchariden, Polysaccharid-Derivaten und Kombinationen von zwei oder mehreren davon.

32. Verfahren gemäß einem der Ansprüche 29-31, wobei die Sauerstoffgas-Barriereschicht (12) in einer Gesamtmenge von 0,1 bis 5 g/m² Trockengewicht, vorzugsweise von 0,5 bis 3,5 g/m², bevorzugter von 0,5 bis 2 g/m², aufgebracht wird.

33. Verfahren gemäß einem der Ansprüche 29-32, wobei die Sauerstoffgas-Barriereschicht (12) in zwei oder mehr aufeinanderfolgenden Schritten mit dazwischenliegendem Trocknen als zwei oder mehr Teilschichten in einer Menge von jeweils 0,5 bis 2 g/m², bevorzugter jeweils 0,5 bis 1 g/m², aufgebracht wird.

34. Verfahren gemäß einem der Ansprüche 29-33, ferner umfassend folgende Schritte
- Bereitstellen eines Polymersubstratfilms (23) und
- Aufdampfen einer Barriereschicht (14; 23a) auf den Polymersubstratfilm (23).

35. Verfahren gemäß einem der Ansprüche 29-34, wobei der Polymersubstratfilm (34a) für das Aufdampfen durch Extrusionsblasen (32) eines Films, der die innerste heißsiegelfähige Polymerschicht (15; 23) umfasst, hergestellt wird.

36. Verfahren gemäß Anspruch 35, ferner umfassend den Schritt des Monoorientierens (36) des geblasenen Polymersubstratfilms (34) vor dem Aufdampfbeschichten, wobei der Polymersubstratfilm (34a) hauptsächlich lineares Polyethylen mit niedriger Dichte umfasst.

37. Verfahren gemäß Anspruch 36, wobei der Polymersubstratfilm (23; 34a), der hauptsächlich lineares Polyethylen mit niedriger Dichte umfasst, auf eine Dicke von 20 µm oder weniger, vorzugsweise 15 µm oder weniger, monoorientiert (36) wird.

38. Verfahren gemäß einem der Ansprüche 29-37, wobei eine Schicht von Aluminiummetall oder Aluminiumoxid (14; 23a) auf den Polymersubstratfilm (23; 34a; 44a) aufgedampft wird (40).

39. Verfahren gemäß einem der Ansprüche 29-38, wobei die aufgedampfte Barriereschicht (14; 23a) mit einer Dicke von 5 bis 200 nm (von 50 bis 2000 Å) aufgebracht wird.

40. Verfahren gemäß einem der Ansprüche 29-39, wobei der aufgedampfte Barriereschicht-beschichtete Film (14-15; 23-23a) mittels Extrusionslamination mit einer Polymer-Zwischenschicht (13; 24) auf die Innenseite der Sauerstoffgas-Barriereschicht (12) laminiert wird.

41. Verfahren gemäß einem der Ansprüche 29-39, wobei die Polymer-Zwischenschicht (13; 24) eine thermoplastische bindende Schicht ist und die aufgedampfte Barriereschicht (14; 23a) aus einer Metallverbindung ist, ferner umfassend die Schritte des Flüssigfilm-Beschichtens der Polymer-Zwischenschicht (13) auf die aufgebrachte Sauerstoffgas-Barriereschicht (12), Trocknen und anschließendes Hitze-Druck-Laminieren des aufgedampften Barriereschicht-beschichteten Films (14-15; 23-23a) auf die Polymer-Zwischenschicht (13).

42. Verpackungsbehälter (50a; 50b), hergestellt aus dem Verpackungslaminat (10a; 10b) gemäß einem der Ansprüche 1-28.

## Revendications

1. Stratifié d'emballage (10a ; 10b) ayant des propriétés de barrière aux gaz, pour emballage d'un produit alimentaire liquide, comprenant une couche centrale (11 ; 11') de papier ou de carton, une première couche de polyoléfine, extérieure, étanche aux liquides, thermoscellable (16), une deuxième couche de polyoléfine, intérieure, étanche aux liquides, thermoscellable (15) et, appliquée directement sur et contiguë au côté intérieur de la couche centrale (11 ; 11') de papier ou de carton, une couche barrière à l'oxygène gazeux (12) formée par application d'un film liquide d'une composition liquide faisant barrière aux gaz et séchage consécutif, la composition liquide contenant un liant polymère dispersé ou dissous dans un milieu aqueux ou solvant, le stratifié d'emballage comprenant en outre une couche barrière déposée en phase vapeur (14) appliquée sur un film de substrat polymère, ledit film de substrat polymère comprenant éventuellement la couche de polyoléfine intérieure thermoscellable (15), laquelle couche barrière déposée en phase vapeur (14) étant disposée entre ladite couche barrière à l'oxygène gazeux (12) et ladite couche de polyoléfine intérieure thermoscellable (15), et le film avec couche barrière déposée en phase vapeur (14-15) étant lié à la couche centrale avec couche barrière à l'oxygène gazeux (11-12) par une couche polymère intermédiaire (13).

2. Stratifié d'emballage pour emballage alimentaire liquide selon la revendication 1, **caractérisé en ce que** ladite couche barrière à l'oxygène gazeux comprend de 60 à 99 % en poids dudit liant polymère, sur la base du poids de revêtement sec.

3. Stratifié d'emballage pour emballage alimentaire liquide selon l'une quelconque des revendications 1 et 2, **caractérisé en ce que** ledit liant polymère est un polymère ayant des propriétés de barrière aux gaz.

4. Stratifié d'emballage pour emballage alimentaire liquide selon l'une quelconque des revendications 1 à 3, **caractérisé en ce que** ledit liant polymère est choisi dans le groupe constitué par les polymères à base d'alcool vinylique, de préférence tels que le PVOH ou l'EVOH dispersible dans l'eau, et les polymères d'acide acrylique ou d'acide méthacrylique, les polysaccharides, les dérivés de polysaccharides et les combinaisons d'au moins deux de ceux-ci.

5. Stratifié d'emballage pour emballage alimentaire liquide selon l'une quelconque des revendications 1 et 2, **caractérisé en ce que** ledit liant polymère est le PVOH, ayant de préférence un degré de saponification d'au moins 98 %, mieux d'au moins 99 %.

6. Stratifié d'emballage selon l'une quelconque des revendications 1 à 5, **caractérisé en ce que** ladite composition liquide comprend en outre des particules inorganiques.

7. Stratifié d'emballage selon la revendication 6, **caractérisé en ce que** lesdites particules inorganiques sont de forme laminaire ou en forme de paillettes.

8. Stratifié d'emballage selon la revendication 7, **caractérisé en ce que** lesdites particules inorganiques se composent principalement de nanoparticules laminaires d'argile ayant un rapport de forme de 50 à 5000.

9. Stratifié d'emballage selon la revendication 8, **caractérisé en ce que** lesdites particules inorganiques sont dispersées en un état exfolié.

10. Stratifié d'emballage selon l'une quelconque des revendications 7 à 9, **caractérisé en ce que** lesdites particules inorganiques sont la montmorillonite.

11. Stratifié d'emballage selon la revendication 7, **caractérisé en ce que** lesdites particules inorganiques se composent principalement de particules laminaires de talc ayant un rapport de forme de 10 à 500.

12. Stratifié d'emballage selon l'une quelconque des revendications 1 à 11, **caractérisé en ce que** ladite couche barrière à l'oxygène gazeux (12) est appliquée à une quantité totale de 0,1 à 5 g/m², de préférence de 0,5 à 3,5 g/m², mieux de 0,5 à 2 g/m², en poids sec.

13. Stratifié d'emballage selon l'une quelconque des revendications précédentes, **caractérisé en ce que** ladite couche barrière à l'oxygène gazeux (12) est appliquée en au moins deux étapes consécutives avec séchage intermédiaire, sous la forme d'au moins deux couches partielles, à une quantité d'environ 0,5 à 2 g/m² chacune, de préférence de 0,5 à 1 g/m² chacune.

14. Stratifié d'emballage selon l'une quelconque des revendications précédentes, **caractérisé en ce que** la couche barrière déposée en phase vapeur (14) est un composé métallique ou métallique inorganique.

15. Stratifié d'emballage selon l'une quelconque des revendications précédentes, **caractérisé en ce que** la couche barrière déposée en phase vapeur (14) est une couche se composant essentiellement d'aluminium ou d'oxyde d'aluminium.

16. Stratifié d'emballage selon l'une quelconque des revendications 1 à 13, **caractérisé en ce que** la couche barrière déposée en phase vapeur (14) est une couche à base de carbone.

17. Stratifié d'emballage selon l'une quelconque des revendications précédentes, **caractérisé en ce que** la couche barrière déposée en phase vapeur (14) est appliquée à une épaisseur de 5 à 200 nm (de 50 à 2000 Å).

18. Stratifié d'emballage selon l'une quelconque des revendications précédentes, **caractérisé en ce que** le film de substrat polymère pour dépôt en phase vapeur est un film à base de polyoléfine.

19. Stratifié d'emballage selon l'une quelconque des revendications précédentes, **caractérisé en ce que** le film de substrat polymère pour dépôt en phase vapeur comprend également ladite couche de polyoléfine intérieure thermoscellable (15).

20. Stratifié d'emballage selon l'une quelconque des revendications précédentes, **caractérisé en ce que** ladite couche de polyoléfine intérieure thermoscellable (15) se compose principalement de polyéthylène basse densité, et de préférence se compose principalement de polyéthylène basse densité linéaire (LLDPE).

21. Stratifié d'emballage selon l'une quelconque des revendications 18 à 20, **caractérisé en ce que** ledit film de substrat polymère est un film mono-orienté (34a) constitué par ladite couche de polyoléfine intérieure thermoscellable (15).

22. Stratifié d'emballage selon la revendication 21, **caractérisé en ce que** ledit film mono-orienté (15 ; 34a) comprend en majorité du polyéthylène basse densité, de préférence du polyéthylène basse densité linéaire.

23. Stratifié d'emballage selon l'une quelconque des revendications 21 et 22, **caractérisé en ce que** ledit film mono-orienté (15) a une épaisseur de 20 µm ou moins, de préférence 15 µm ou moins.

24. Stratifié d'emballage selon l'une quelconque des revendications 21 à 23, **caractérisé en ce que** ledit film mono-orienté (15) comprend une couche de peau de polyoléfine modifiée avec des groupes fonctionnels, couche de peau sur laquelle la couche barrière déposée en phase vapeur (14) est appliquée.

25. Stratifié d'emballage selon la revendication 24, **caractérisé en ce que** la polyoléfine modifiée est un copolymère éthylène-acide (méth)acrylique (EAA ou EMAA).

26. Stratifié d'emballage selon l'une quelconque des revendications précédentes, **caractérisé en ce que** ledit film avec couche barrière déposée en phase vapeur (14-15) est lié à la couche centrale de papier ou de carton (11 ; 11') par une couche polymère intermédiaire (13) choisie parmi les polyoléfines et les polymères adhésifs à base de polyoléfine.

27. Stratifié d'emballage selon la revendication 26, **caractérisé en ce que** la couche polymère intermédiaire (13) comprend en outre des particules inorganiques sous la forme de pigments noirs pour améliorer les propriétés de barrière à la lumière du stratifié d'emballage.

28. Stratifié d'emballage selon la revendication 26, **caractérisé en ce que** la couche polymère intermédiaire (13) comprend en outre des particules inorganiques sous la forme de pigments blancs pour améliorer les propriétés de barrière à la lumière du stratifié d'emballage.

29. Procédé de fabrication d'un stratifié d'emballage (10a ; 10b ; 29) selon l'une quelconque des revendications 1 à 28, comprenant les étapes consistant à
- se procurer une couche centrale de papier ou de carton (11 ; 11' ; 21a),
- se procurer une composition liquide faisant barrière aux gaz contenant un liant polymère dispersé ou dissous dans un milieu liquide aqueux ou à base de solvant,
- former une couche mince faisant barrière à l'oxygène gazeux (12) comprenant ledit liant polymère par application (22a) de la composition liquide directement sur un premier côté de ladite couche centrale de papier ou de carton (11 ; 11' ; 21a) et séchage consécutif (22b) pour évaporer le liquide,
- laminer un film de substrat polymère avec couche barrière déposée en phase vapeur (23 ; 23a) sur le côté intérieur de la couche barrière à l'oxygène gazeux (12) au moyen d'une couche polymère intermédiaire (13 ; 24),
- former une couche intérieure (15) d'une polyoléfine thermoscellable à l'intérieur de la couche barrière déposée en phase vapeur (14), la couche intérieure (15) se composant éventuellement du film de substrat polymère (23), et
- former une couche extérieure (16 ; 26) d'une polyoléfine thermoscellable à l'extérieur de la couche centrale (11 ; 21a).

30. Procédé selon la revendication 29, dans lequel la composition liquide faisant barrière aux gaz contient en outre des particules inorganiques.

31. Procédé selon l'une quelconque des revendications 29 et 30, dans lequel le polymère faisant barrière à l'oxygène gazeux contenu dans la composition liquide est choisi dans un groupe constitué par le PVOH, l'EVOH dispersible dans l'eau, les polymères d'acide acrylique ou méthacrylique, les polysaccharides, les dérivés de polysaccharides et les combinaisons d'au moins deux de ceux-ci.

32. Procédé selon l'une quelconque des revendications 29 à 31, dans lequel la couche barrière à l'oxygène gazeux (12) est appliquée dans une quantité totale de 0,1 à 5 g/m², de préférence de 0,5 à 3,5 g/m², mieux de 0,5 à 2 g/m², en poids sec.

33. Procédé selon l'une quelconque des revendications 29 à 32, dans lequel la couche barrière à l'oxygène gazeux (12) est appliquée sous la forme d'au moins deux couches partielles en au moins deux étapes consécutives avec séchage intermédiaire, à une quantité de 0,5 à 2 g/m² chacune, de préférence de 0,5 à 1 g/m² chacune.

34. Procédé selon l'une quelconque des revendications 29 à 33, comprenant en outre les étapes consistant à
- se procurer un film de substrat polymère (23), et
- déposer en phase vapeur une couche barrière (14 ; 23a) sur le film de substrat polymère (23).

35. Procédé selon l'une quelconque des revendications 29 à 34, dans lequel le film de substrat polymère (34a) pour dépôt en phase vapeur est produit par extrusion-soufflage (32) d'un film, qui comprend la couche intérieure de polymère thermoscellable (15 ; 23).

36. Procédé selon la revendication 35, comprenant en outre l'étape consistant à mono-orienter (36) le film de substrat polymère soufflé (34) avant application par dépôt en phase vapeur, le film de substrat polymère (34a) comprenant en majorité du polyéthylène basse densité linéaire.

37. Procédé selon la revendication 36, dans lequel le film de substrat polymère (23 ; 34a) comprenant en majorité du polyéthylène basse densité linéaire est mono-orienté (36) jusqu'à une épaisseur de 20 µm ou moins, de préférence 15 µm ou moins.

38. Procédé selon l'une quelconque des revendications 29 à 37, dans lequel une couche d'aluminium métallique ou d'oxyde d'aluminium (14 ; 23a) est déposée en phase vapeur (40) sur le film de substrat polymère (23 ; 34a ; 44a).

39. Procédé selon l'une quelconque des revendications 29 à 38, dans lequel la couche barrière déposée en phase vapeur (14 ; 23a) est appliquée à une épaisseur de 5 à 200 nm (de 50 à 2000 Å).

40. Procédé selon l'une quelconque des revendications 29 à 39, dans lequel le film avec couche barrière déposée en phase vapeur (14-15 ; 23-23a) est laminé sur le côté intérieur de la couche barrière à l'oxygène gazeux (12) par extrusion-laminage avec une couche polymère intermédiaire (13 ; 24).

41. Procédé selon l'une quelconque des revendications 29 à 39, dans lequel la couche polymère intermédiaire (13 ; 24) est une couche de liaison thermoplastique et la couche barrière déposée en phase vapeur (14 ; 23a) est un composé métallique, comprenant en outre les étapes d'application d'un film liquide de la couche polymère intermédiaire (13) sur la couche barrière à l'oxygène gazeux appliquée (12), séchage, et laminage à chaud et sous pression consécutif du film avec couche barrière déposée en phase vapeur (14-15 ; 23-23a) sur la couche polymère intermédiaire (13).

42. Contenant d'emballage (50a ; 50b) fabriqué à partir du stratifié d'emballage (10a ; 10b) tel que spécifié dans l'une quelconque des revendications 1 à 28.
